# EUROPEAN PATENT APPLICATION

(11) **EP 3 869 528 A1**
(43) Date of publication of application: **25.08.2021**
(21) Application number: 19873385.9
(22) Date of filing: 02.10.2019
(51) Int. Cl.: H01H 13/00, H01L 41/113, H02N 2/18, H01H 13/20

(54) **INPUT APPARATUS**

(30) Priority: 16.10.2018 JP 2018195210
(71) Applicant: Panasonic Intellectual Property Management Co., Ltd., Osaka-shi, Osaka 540-6207 (JP)
(72) Inventor: KOBAYASHI, Yoshiyuki, Osaka-shi, Osaka 540-6207 (JP); NAKAMURA, Takaya, Osaka-shi, Osaka 540-6207 (JP); FUDO, Kohei, Osaka-shi, Osaka 540-6207 (JP); HOSHINO, Tsubasa, Osaka-shi, Osaka 540-6207 (JP)
(74) Representative: Grünecker Patent- und Rechtsanwälte PartG mbB
(86) International application number: PCT/JP2019/038969
(87) International publication number: WO 2020/080114

(57) **Abstract**

It is an object to provide an input apparatus configured to adjust first operation force which gives a push operation to the first operation section and second operation force which gives a push operation to the second operation section. An input apparatus (1) includes a first operation section (3A) configured to receive a push operation, a second operation section (3B) configured to receive a push operation, a first pivot member (4) configured to pivot, a second pivot member (5) configured to pivot, a first switch (70A), a second switch (70B), and a power generation device (6). The power generation device (6) is configured to generate electric power when the first pivot member (4) pivots. When the first operation section (3A) is pushed, the first switch (70A) is turned ON and the first pivot member (4) directly receives force from the first operation section (3A) to pivot. When the second operation section (3B) is pushed, the second switch (70B) is turned ON and the first pivot member (4) indirectly receives force from the second operation section (3B) via the second pivot member (5) to pivot.

## Description

### Technical Field

The present disclosure generally relates to an input apparatus, and specifically, to an input apparatus including a power generation device.

### Background Art

A power generation device (an input apparatus) including a vibration power generation element (a power generation device) has been disclosed (see, for example, Patent Literature 1).

The power generation device disclosed in Patent Literature 1 includes a vibration power generation element. The vibration power generation element includes a supporting part and a vibrator. The vibrator includes a piezoelectric transducer and is swingably supported by the supporting part. The vibration power generation element vibrates to generate electrical energy.

### Citation List

### Patent Literature

Patent Literature 1: JP 2016-086599 A

### Summary of Invention

By the way, when an input apparatus includes a plurality of operation sections for driving a power generation device in interconnection with a push operation, adjusting operation force which gives a push operation to each operation section is desirable.

In view of the foregoing, it is an object of the present disclosure to provide an input apparatus configured to adjust first operation force which gives a push operation to a first operation section and second operation force which gives a push operation to a second operation section.

An input apparatus according to one aspect of the present disclosure includes a first operation section configured to receive a push operation, a second operation section configured to receive a push operation, a first pivot member configured to pivot, a second pivot member configured to pivot, a first switch, a second switch, and a power generation device. The power generation device is configured to generate electric power when the first pivot member pivots. When the first operation section is pushed, the first switch is turned ON and the first pivot member directly receives force from the first operation section to pivot. When the second operation section is pushed, the second switch is turned ON and the first pivot member indirectly receives force from the second operation section via the second pivot member to pivot.

### Brief Description of Drawings

FIG. 1 is an exploded perspective view illustrating an input apparatus according to an embodiment of the present disclosure;
FIG. 2 is a perspective view illustrating the input apparatus with its case removed;
FIG. 3 is a block diagram illustrating the input apparatus;
FIGS. 4A to 4C are views illustrating operation of a power generation device in the input apparatus;
FIGS. 5A and 5B are views illustrating operation when a first operation section of the input apparatus is pushed;
FIGS. 6A and 6B are views illustrating operation when a second operation section of the input apparatus is pushed;
FIG. 7 is a time chart when the first operation section of the input apparatus is pushed;
FIG. 8 is an exploded perspective view illustrating an input apparatus according to a first variation of the embodiment of the present disclosure;
FIGS. 9A and 9B are views illustrating operation when a third operation section of the input apparatus of the first variation is pushed;
FIG. 10 is an exploded perspective view illustrating an input apparatus according to a second variation of the embodiment of the present disclosure;
FIG. 11 is a perspective view illustrating the input apparatus of the second variation with its case removed;
FIG. 12 is a perspective view illustrating a case body of the case of the second variation viewed from above;
FIG. 13 is an exploded perspective view illustrating the input apparatus of the second variation with its lower cover being exploded and viewed from below;
FIG. 14A is an exploded perspective view illustrating a first operation structural component of the input apparatus of the second variation viewed from below;
FIG. 14B is a perspective view illustrating the first operation structural component of the second variation viewed from below;
FIG. 15A is an exploded perspective view illustrating a second operation structural component of the input apparatus of the second variation viewed from below;
FIG. 15B is a perspective view illustrating the second operation structural component of the second variation viewed from below;
FIGS. 16A and 16B are views illustrating operation of a power generation device in the input apparatus of the second variation;
FIGS. 17A and 17B are views illustrating operation when a first operation section of the input apparatus of the second variation is pushed;
and FIGS. 18A and 18B are views illustrating operation when a second operation section of the input apparatus of the second variation is pushed.

### Description of Embodiments

The embodiment and variations described below are mere examples of the present disclosure. The present disclosure is not limited to the embodiment and the variations. The present disclosure may be modified variously without departing from the scope of technical idea of the present disclosure, even if not including the embodiment and the variations, according to design or the like.

### (1) Schema

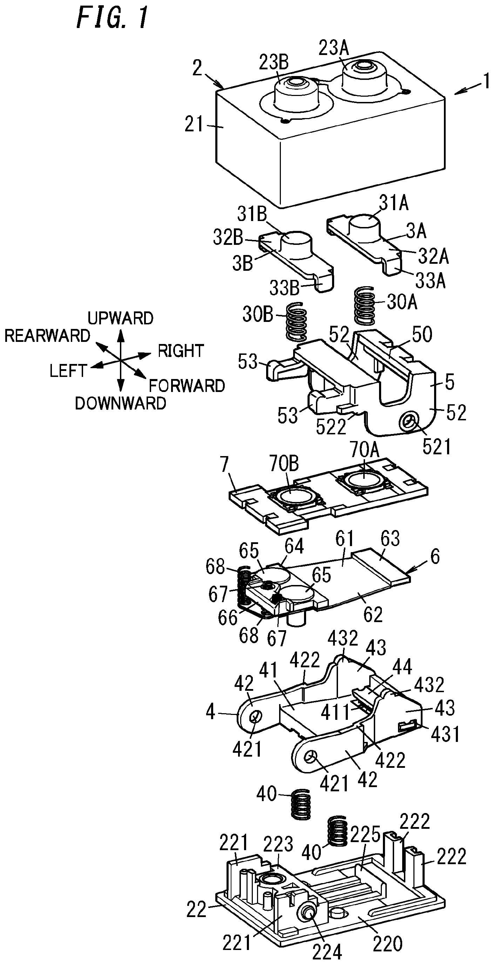

With reference to FIGS. 1 to 7, an input apparatus 1 of the present embodiment will be described.

The input apparatus 1 of the present embodiment includes a first operation section 3A configured to receive a push operation, a second operation section 3B configured to receive a push operation, a first pivot member 4 configured to pivot, a second pivot member 5 configured to pivot, a first switch 70A, a second switch 70B, and a power generation device 6 configured to generate electric power when the first pivot member 4 pivots.

When the first operation section 3A is pushed, the first switch 70A is turned ON, and the first pivot member 4 directly receives force from the first operation section 3A to pivot. When the second operation section 3B is pushed, the second switch 70B is turned ON, and the first pivot member 4 indirectly receives force from the second operation section 3B via the second pivot member 5 to pivot.

That is, when the first operation section 3A or the second operation section 3B in the input apparatus 1 of the present embodiment is pushed, the first pivot member 4 is directly or indirectly pushed to pivot, and the power generation device 6 is driven to generate electric power. Thus, the input apparatus 1 is configured to generate electric power along with a push operation given to the first operation section 3A or the second operation section 3B.

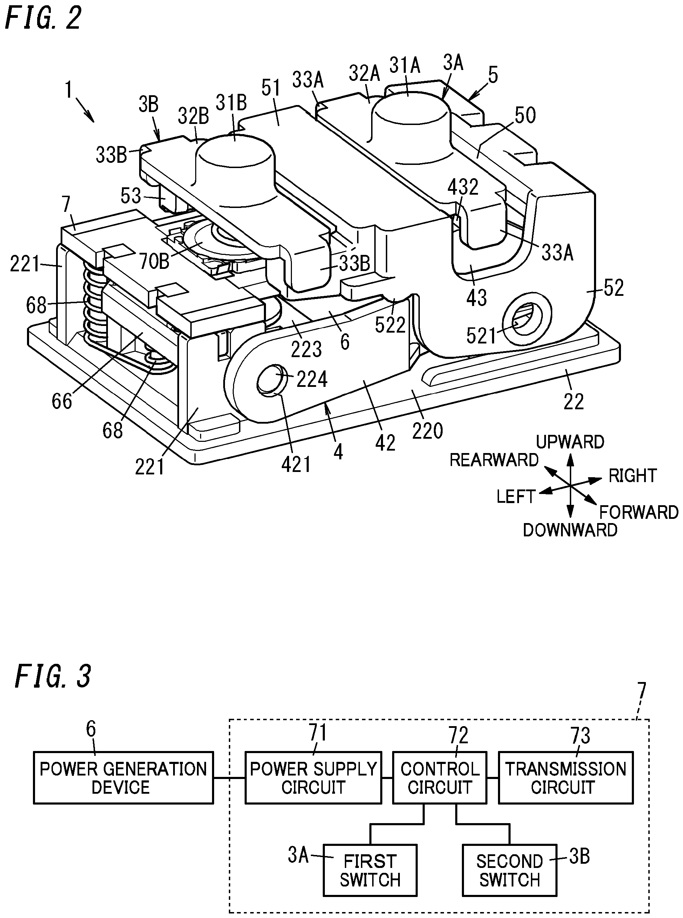

The input apparatus 1 of the present embodiment further includes a power supply circuit 71, a control circuit 72, and a transmission circuit 73 (see FIG. 3) which are supplied with electric power from the power generation device 6. The power supply circuit 71, the control circuit 72, and the transmission circuit 73 include a substrate 7 provided in a housing 2 and circuit elements mounted on the substrate 7. The transmission circuit 73 is configured to output a radio signal by using electric power generated by the power generation device 6. That is, in the input apparatus 1, the electric power generated by the power generation device 6 enables communication circuits (the transmission circuit 73 and the like) to operate and output the radio signal. Thus, the input apparatus 1 requires no electric power separately supplied from a battery, a commercial power supply, or the like.

### (2) Details

The input apparatus 1 according to the present embodiment will be explained in detail below.

Unless otherwise noted, a travel direction of the first operation section 3A and the second operation section 3B is defined as an upward/downward direction, a direction in which the first operation section 3A and the second operation section 3B are aligned is defined as a rightward/leftward direction, and a direction orthogonal to the upward/downward direction and the rightward/leftward direction is defined as a forward/rearward direction in the following description. Moreover, a direction in which the first operation section 3A and the second operation section 3B move when the first operation section 3A and the second operation section 3B are pushed is defined as a downward direction, and a direction in which the second operation section 3B is provided to the first operation section 3A is defined as a leftward direction in the following description. That is, "upward", "downward", "left", "right", "forward", and "rearward" arrows illustrated in FIG. 1 or the like represent in a straightforward manner the upward, downward, left, right, forward, and rearward directions, respectively. However, there is no intent to use these directions to limit directions of the input apparatus 1 in use. Additionally, the arrows representing the directions in figures are described only for facilitating understanding and are intangible.

The input apparatus 1 includes the housing 2. The housing 2 accommodates the first operation section 3A, the second operation section 3B, the first switch 70A, the second switch 70B, the first pivot member 4, the second pivot member 5, the power generation device 6, and the like.

The housing 2 is made of a synthetic resin and is in the form of a rectangular parallelepiped. The housing 2 includes a case 21 and a lower cover 22. The case 21 is formed in a rectangular box shape whose lower surface is an opening. The lower cover 22 has a bottom part 220 which has a rectangular plate shape. The opening of the case 21 and the bottom part 220 of the lower cover 22 are connected to each other at their peripheral portions, thereby forming the housing 2. The case 21 and the lower cover 22 are connected to each other by, for example, laser welding. Thus, in the input apparatus 1, water or the like is suppressed from entering the housing 2 through a location where the case 21 and the lower cover 22 are connected to each other. Moreover, the input apparatus 1 includes the power generation device 6 and does thus not require a battery or the like. The housing 2 of the input apparatus 1 requires no space for accommodation of the battery or the like and requires no lid which allows access to the space. This can improve the waterproofing property of the housing 2. Therefore, the input apparatus 1 is particularly suitable for outdoor use.

The first operation section 3A and the second operation section 3B are aligned in the rightward/leftward direction. The first operation section 3A is disposed on the right of the second operation section 3B.

The first operation section 3A is made of a synthetic resin. The first operation section 3A includes a projection 31A, a pressing piece 32A, and a pair of protruding pieces 33A. The pressing piece 32A has a rectangular plate shape elongated in the forward/rearward direction. The projection 31A has a columnar shape to protrude upward from a central part of an upper surface of the pressing piece 32A. The pair of protruding pieces 33A protrude downward from respective ends of the pressing piece 32A in the forward/rearward direction.

The first operation section 3A is incorporated into the case 21 such that the projection 31A extends from a lower side through a through hole formed in an upper surface of the case 21. Thus, a tip end (an upper end) of the projection 31A passes through the through hole and protrudes upward from an upper surface of the housing 2.

Moreover, the pair of protruding pieces 33A are incorporated into the case 21 to be fit in a pair of guide grooves formed in inner surfaces of the case 21. The pair of guide grooves are formed in both front and rear inner surfaces of the case 21 to extend along the upward/downward direction. The pair of protruding pieces 33A are fit in the pair of guide grooves, thereby restricting the travel direction of the first operation section 3A to the upward/downward direction.

On the upper surface of the case 21, a waterproof rubber member 23A is provided at a peripheral portion of the through hole through which the projection 31A extends. The waterproof rubber member 23A has a dome shape and covers the projection 31A and the through hole through which the projection 31A extends. The waterproof rubber member 23A is satisfactorily flexible so that the first operation section 3A can be pushed via the waterproof rubber member 23A. The upper surface of the pressing piece 32A comes into contact with the waterproof rubber member 23A or an inner surface of the case 21, thereby restricting the projection dimension of the projection 31A from the upper surface of the housing 2 to a defined dimension or smaller. Note that the waterproof rubber member 23A and the case 21 are preferably integrally molded by, for example, two-color molding or the like. Thus, in the input apparatus 1, a gap can be suppressed from being formed between the waterproof rubber member 23A and the case 21, and water and the like can be suppressed from entering the housing 2.

The first switch 70A is disposed under the first operation section 3A. Specifically, the first switch 70A is disposed on an upper surface of the substrate 7 accommodated in the housing 2 and under the projection 31A of the first operation section 3A. The substrate 7 is a printed circuit board, and the first switch 70A is mounted on the substrate 7. Between the projection 31A and the first switch 70A, a first spring 30A is disposed. The first spring 30A is a coil spring and is sandwiched between the projection 31A and the first switch 70A. The projection 31A has a hollow in which an upper end of the first spring 30A is fit. This achieves positioning of the first spring 30A.

The first operation section 3A is at an upper end position in a movable range due to the elastic force of the first spring 30A in a steady state where the first operation section 3A is not pushed. The position of the first operation section 3A at this time is referred to as a "reference position" in the following description. When the first operation section 3A is at the reference position, the first switch 70A is OFF. The first operation section 3A moves downward from the reference position and compresses the first spring 30A in a state where the first operation section 3A is pushed, and downward force applied to the first operation section 3A is transmitted via the first spring 30A to the first switch 70A. The position of the first operation section 3A at this time is referred to as an "operating position" in the following description. When the first operation section 3A is at the operating position, the first switch 70A is ON. When force pushing the first operation section 3A is no longer applied, the elastic force of the first spring 30A returns the first operation section 3A to the reference position, so that the first switch 70A is turned OFF.

In sum, the first operation section 3A linearly moves between the reference position and the operating position along the upward/downward direction in accordance with an operation given by a user. Then, when the first operation section 3A is at the reference position at which the steady state is achieved, the first switch 70A is OFF, and when the first operation section 3A is at the operating position, the first switch 70A is ON. Thus, the first operation section 3A and the first switch 70A form a momentary push button switch, that is, the first switch 70A is in an ON state only while the first operation section 3A is pushed.

The second operation section 3B, the second switch 70B, and the second spring 30B adopt configurations respectively common to the configurations of the first operation section 3A, the first switch 70A, and the first spring 30A, and therefore, the detailed description thereof is accordingly omitted. The second operation section 3B, the second switch 70B, and the second spring 30B are respectively disposed on the left of the first operation section 3A, the first switch 70A, and the first spring 30A.

The second operation section 3B includes a projection 31B, a pressing piece 32B, and a pair of protruding pieces 33B. The projection 31B, the pressing piece 32B, and the pair of protruding pieces 33B respectively have the same configurations as the projection 31A, the pressing piece 32A, the pair of protruding pieces 33A of the first operation section 3A.

The second operation section 3B is incorporated into the case 21 such that the projection 31B extends from the lower side through a through hole formed in the upper surface of the case 21. Thus, a tip end (an upper end) of the projection 31B passes through the through hole and protrudes from the upper surface of the housing 2.

Moreover, the pair of protruding pieces 33B are incorporated into the case 21 to be fit in a pair of guide grooves formed in the inner surfaces of the case 21. Thus, the travel direction of the second operation section 3B is restricted to the upward/downward direction.

On the upper surface of the case 21, a waterproof rubber member 23B is provided at a peripheral portion of the through hole through which the projection 31B extends. The waterproof rubber member 23B has the same configuration as the waterproof rubber member 23A and covers the projection 31B and the through hole through which the projection 31B extends. In the present embodiment, the waterproof rubber member 23A and the waterproof rubber member 23B are continuous to each other and are molded as one piece.

The second switch 70B is disposed on the upper surface of the substrate 7 and under the projection 31B of the second operation section 3B. Between the projection 31B and the second switch 70B, a second spring 30B is disposed.

The second operation section 3B linearly moves between the reference position and the operating position along the upward/downward direction in accordance with an operation given by a user. Then, when the second operation section 3B is at the reference position at which the steady state is achieved, the second switch 70B is OFF, and when the second operation section 3B is at the operating position, the second switch 70B is ON. Thus, the second operation section 3B and the second switch 70B form a momentary push button switch, that is, the second switch 70B is in the ON state only while the second operation section 3B is pushed.

The substrate 7 is supported by a pair of first supporting parts 221 and a pair of second supporting parts 222 which are provided to the bottom part 220 of the lower cover 22. The bottom part 220 of the lower cover 22 is further provided with a support table 223 protruding upward from a left end of the bottom part 220. The pair of first supporting parts 221 protrude upward from both front and rear sides of the support table 223. The pair of second supporting parts 222 protrude upward from a right end of the bottom part 220 of the lower cover 22. The pair of second supporting parts 222 are aligned in the forward/rearward direction. The substrate 7 is disposed to be in contact with upper surfaces of the pair of first supporting parts 221 and the pair of second supporting parts 222.

In addition to the first switch 70A and the second switch 70B described above, electronic components forming the power supply circuit 71, the control circuit 72, the transmission circuit 73, and the like are mounted on the substrate 7 (see FIG. 3).

The power supply circuit 71 is electrically connected to the power generation device 6. When the first operation section 3A or the second operation section 3B is pushed, the power generation device 6 performs power generation to generate an AC voltage, which will be described later in detail. The power supply circuit 71 includes a rectifier circuit, a capacitor, a DC/DC converter, and the like. The rectifier circuit is configured to rectify the AC voltage generated by the power generation device 6. The capacitor is electrically connected between output ends of the rectifier circuit and is configured to smooth a voltage output from the rectifier circuit. The DC/DC converter is electrically connected between both ends of the capacitor, converts a voltage across the capacitor into a prescribed direct-current voltage, and outputs the prescribed direct-current voltage to the control circuit 72 and the transmission circuit 73.

The control circuit 72 detects states of the first switch 70A and the second switch 70B to determine which operation section of the first operation section 3A and the second operation section 3B is pushed. If the first operation section 3A is pushed, the control circuit 72 causes the transmission circuit 73 to output a radio signal including first information, and if the second operation section 3B is pushed, the control circuit 72 causes the transmission circuit 73 to output a radio signal including second information.

That is, in the input apparatus 1, when the first operation section 3A or the second operation section 3B is pushed, the power generation device 6 generates electric power. Then, electric power generated by the power generation device 6 is used to output a radio signal according to the operation section pushed, of the first operation section 3A or the second operation section 3B.

In the housing 2, the power generation device 6 is disposed under the substrate 7. The power generation device 6 includes a vibrator 61 and piezoelectric elements 62.

The vibrator 61 has a substantially trapezoidal plate shape in plan view. The dimension in the forward/rearward direction of a right end of the vibrator 61 is smaller than the dimension in the forward/rearward direction of a left end of the vibration body 61. The vibrator 61 is formed from an elastic plate material, such as, a metal plate made of, for example, stainless steel (SUS304). The piezoelectric elements 62 are provided on both surfaces in a thickness direction (the upward/downward direction) of the vibrator 61. The piezoelectric elements 62 are pasted to the vibrator 61 by, for example, adhesion. Thus, the vibrator 61 and the piezoelectric elements 62 are integrated with each other.

The vibrator 61 has a cantilever beam structure in which one end (in the present embodiment, the left end) in the longitudinal direction (the rightward/leftward direction) is a fixed end and the other end (in the present embodiment, the right end) is a free end. The vibrator 61 in a cantilever state warps, and thereby, the right end, which is the free end, of the vibrator 61 can vibrate in the upward/downward direction which is the thickness direction of the vibrator 61. Vibration of the vibrator 61 in the upward/downward direction distorts the piezoelectric elements 62, so that the elements 62 generate electric power. That is, vibration energy of the vibrator 61 in the upward/downward direction (a vibration direction) is converted by the piezoelectric elements 62 into electrical energy.

In the present embodiment, an end (the left end), at the side of the fixed end, of the vibrator 61 is fixed to the lower cover 22, thereby being held by the housing 2. Specifically, the left end of the vibrator 61 is sandwiched between the support table 223 provided to the bottom part 220 of the lower cover 22 and an attachment board 64 in the upward/downward direction, and thereby, the vibrator 61 is held by the housing 2. Moreover, the vibrator 61 has a pair of through holes penetrating the vibrator 61 in the thickness direction (the upward/downward direction). The attachment board 64 is fixed to the support table 223 with a pair of attachment screws 65 through the pair of through holes formed in the vibrator 61.

The power generation device 6 is electrically connected to the substrate 7 via a pair of first contact point springs 67 and a pair of second contact point springs 68 which are electrically conductive. The pair of first contact point springs 67 are held by a spring holder 66 provided to the vibrator 61. The spring holder 66 is provided on the left of the attachment board 64 on an upper surface of the vibrator 61. The pair of first contact point springs 67 are fit in a pair of through holes penetrating the spring holder 66 in the upward/downward direction, and thereby, the spring holder 66 holds the pair of first contact point springs 67. The pair of first contact point springs 67 are sandwiched between the piezoelectric element 62 on the upper surface of the vibrator 61 and a lower surface of the substrate 7 in the upward/downward direction. One of the pair of second contact point springs 68 is sandwiched between the piezoelectric element 62 provided on a lower surface of the vibrator 61 and the bottom part 220 of the lower cover 22 in the upward/downward direction, and the other of the pair of second contact point springs 68 is sandwiched between the bottom part 220 of the lower cover 22 and the lower surface of the substrate 7 in the upward/downward direction. The pair of second contact point springs 68 are coupled and electrically connected to each other. With this configuration, the piezoelectric elements 62 provided on both surfaces of the vibrator 61 are electrically connected to the substrate 7 via the pair of first contact point springs 67 and the pair of second contact point springs 68.

The power generation device 6 further includes a magnetic weight 63. The magnetic weight 63 is provided on an upper surface of an end (the right end), at the side of the free end, of the vibrator 61. The magnetic weight 63 is fixed to the vibrator 61 by, for example, adhesion or welding. The magnetic weight 63 has a rectangular plate shape elongated in the forward/rearward direction in plan view. The magnetic weight 63 is formed from a magnetic metal plate made of, for example, stainless steel (SUS430). The weight of the magnetic weight 63 provided at the free end of the vibrator 61 can increase the number of vibrations of the vibrator 61.

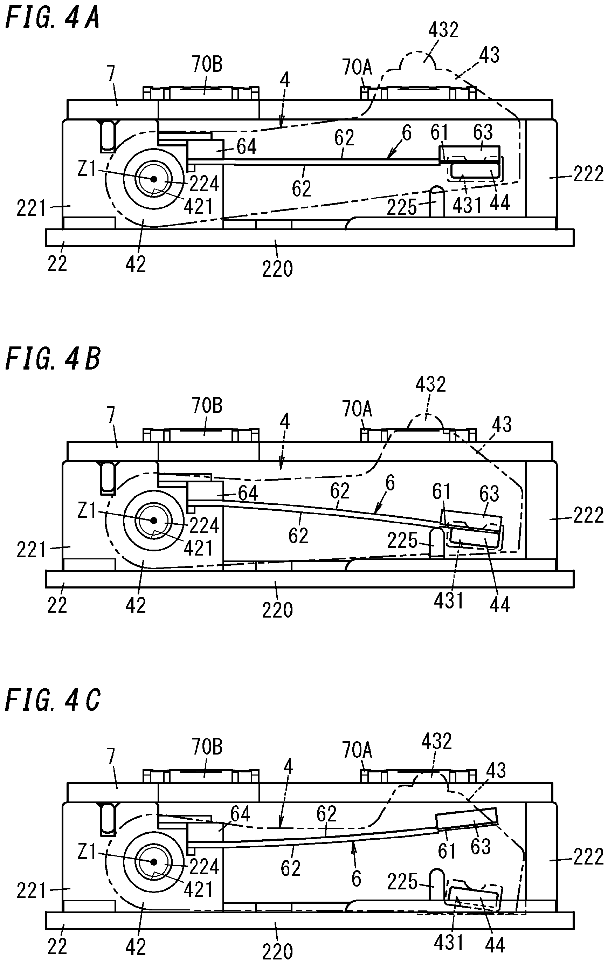

The first pivot member 4 is attached to the pair of first supporting parts 221 provided to the bottom part 220 of the lower cover 22. The first pivot member 4 is configured to pivot about a first pivot axis Z1 (see FIGS. 4A to 4C) along the forward/rearward direction in interconnection with the movement of the first operation section 3A and the second operation section 3B. Moreover, the first pivot member 4 holds a magnet 44. The magnet 44 is magnetically coupled to the magnetic weight 63 of the power generation device 6. When the first pivot member 4 pivots, the magnetic weight 63 moves downward together with the magnet 44. This enables the vibrator 61 to warp to vibrate.

Specifically, the first pivot member 4 includes a bottom part 41, a pair of attachment pieces 42, and a pair of holder pieces 43.

The bottom part 41 has a substantially trapezoidal plate shape in plan view. The dimension in the forward/rearward direction of a right end of the bottom part 41 is smaller than the dimension in the forward/rearward direction of a left end of the bottom part 41. The bottom part 41 has a thickness direction in the upward/downward direction and is located between the vibrator 61 of the power generation device 6 and the bottom part 220 of the lower cover 22.

The pair of attachment pieces 42 are provided on both front and rear sides of the bottom part 41. The pair of attachment pieces 42 each have a plate shape having a thickness direction in the forward/rearward direction. The pair of attachment pieces 42 protrude upward and leftward from the left end of the bottom part 41. Each of the pair of attachment pieces 42 has a through hole 421 which is circular and which is formed on the left of the bottom part 41 to penetrate a corresponding one of the attachment pieces 42 in the forward/rearward direction. Each of the pair of first supporting parts 221 provided to the lower cover 22 has a projection 224 which is columnar. The projection 224 on the first supporting part 221, provided at the front side, of the pair of first supporting parts 221 protrudes forward, and the projection 224 on the first the first supporting part 221, provided at the rear side, of the pair of first supporting parts 221 protrudes rearward. The pair of projections 224 provided to the pair of first supporting parts 221 are fit in the pair of through holes 421 formed in the pair of attachment pieces 42, and thereby, the first pivot member 4 is attached to the lower cover 22. The first pivot member 4 is configured to be pivotable about the first pivot axis Z1 which extends along the forward/rearward direction through the center of each of the pair of through holes 421. Thus, the bottom part 41 of the first pivot member 4 moves in the upward/downward direction between the vibrator 61 of the power generation device 6 and the bottom part 220 of the lower cover 22.

The pair of holder pieces 43 are provided on both front and rear sides of the bottom part 41. The pair of holder pieces 43 each have a plate shape having a thickness direction in the forward/rearward direction. The pair of holder pieces 43 protrude upward from the right end of the bottom part 41.

The pair of holder pieces 43 are provided at locations on the right from the pair of attachment pieces 42 and on the inner side of the attachment pieces 42. Specifically, the pair of holder pieces 43 are provided on the right from the pair of attachment pieces 42 and between the pair of attachment pieces 42 in the forward/rearward direction.

The pair of holder pieces 43 each have a through hole 431 which is rectangular, which is at a higher part of a corresponding one of the pair of holder pieces 43 than the bottom part 41 and which penetrates the corresponding one of the pair of holder pieces 43 in the forward/rearward direction. The magnet 44 has a rectangular plate shape having a longitudinal direction in the forward/rearward direction. The magnet 44 is held by the pair of holder pieces 43 to extend through the pair of through holes 431 formed in the pair of holder pieces 43. That is, the magnet 44 is held between the bottom part 41 and the vibrator 61 of the power generation device 6 in the upward/downward direction. The magnet 44 has both surfaces which are magnetic pole surfaces in the upward/downward direction. Thus, the magnet 44 and the magnetic weight 63 provided at the free end of the vibrator 61 are magnetically coupled to each other. Thus, as the first pivot member 4 pivots, the magnet 44 and the magnetic weight 63 magnetically attracted to the magnet 44 move, thereby warping the vibrator 61. Detailed operation that vibrates the vibrator 61 will be described later.

The bottom part 220 of the lower cover 22 is provided with a restriction piece 225. The restriction piece 225 defines a lower limit position of the free end (the right end) of the vibrator 61 in the movable range. The restriction piece 225 is provided along the forward/rearward direction to protrude upward from the bottom part 220 of the lower cover 22. The bottom part 41 of the first pivot member 4 has a through hole 411 which is rectangular and which is at a location corresponding to the restriction piece 225. The restriction piece 225 extends through the through hole 411, and a tip end (an upper end) of the restriction piece 225 comes into contact with the vibrator 61, thereby defining the lower limit position of the free end of the vibrator 61 in the movable range.

Moreover, between the bottom part 41 of the first pivot member 4 and the bottom part 220 of the lower cover 22, a pair of return springs 40 are disposed. The pair of return springs 40 are coil springs and are aligned in the forward/rearward direction. The pair of return springs 40 are sandwiched between the bottom part 41 of the first pivot member 4 and the bottom part 220 of the lower cover 22. The pair of return springs 40 apply elastic force to the first pivot member 4 such that the first pivot member 4 is at the upper limit position in the movable range. In the following description, the upper limit position of the first pivot member 4 in the movable range is referred to as a "first start position" (see FIGS. 4A, 5A, and 6A).

The pair of holder pieces 43 have a pair of first pressure receiving parts 432 provided at upper ends thereof. The pair of first pressure receiving parts 432 protrude upward from the upper ends of the pair of holder pieces 43. That is, the pair of first pressure receiving parts 432 are provided on both sides in the forward/rearward direction with respect to the substrate 7 and the power generation device 6. The pair of first pressure receiving parts 432 have upper surfaces which are curved. The pair of first pressure receiving parts 432 are in contact with the pressing piece 32A of the first operation section 3A. The pair of first pressure receiving parts 432 receive downward force from the pressing piece 32A when the first operation section 3A is pushed. Thus, the first pivot member 4 pivotally moves about the first pivot axis Z1 to a lower end position in the movable range while compressing the pair of return springs 40. In the following description, the lower limit position of the first pivot member 4 in the movable range is referred to as a "first end position" (see FIGS. 4C, 5B, and 6B).

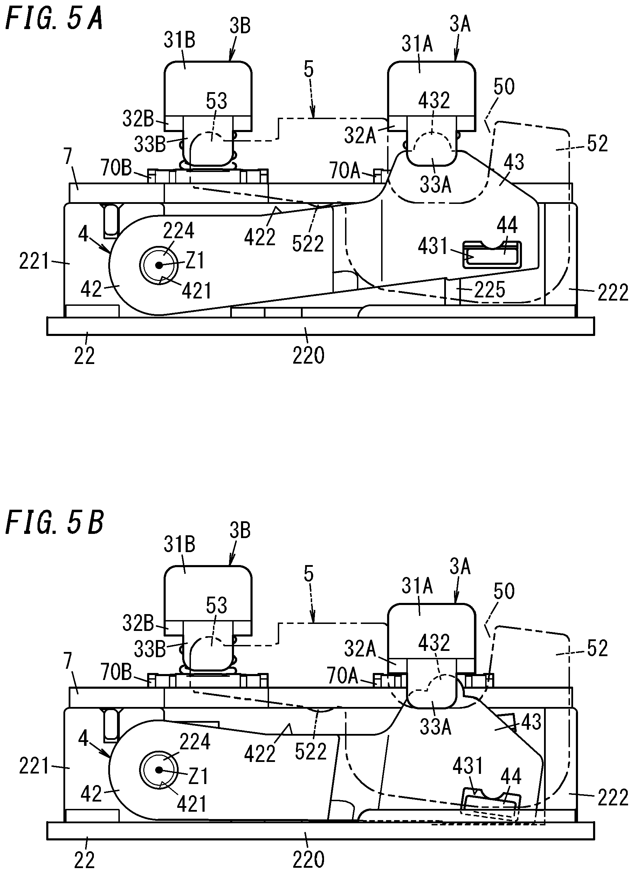

That is, when the first operation section 3A is pushed, the first pivot member 4 pivots about the first pivot axis Z1 in a clockwise direction when viewed in one of directions (from the front) along the first pivot axis Z1 (see FIGS. 4A to 4C, 5A, and 5B).

Moreover, the first pivot member 4 further includes a pair of second pressure receiving parts 422. The pair of second pressure receiving parts 422 are upper ends at a right end side of the pair of attachment pieces 42. The pair of second pressure receiving parts 422 are in contact with a pair of pressing parts 522 of the second pivot member 5. The pair of second pressure receiving parts 422 receive downward force from the second pivot member 5 when the second operation section 3B is pushed. Thus, the first pivot member 4 pivotally moves about the first pivot axis Z1 to the lower end position (the first end position) in the movable range while compressing the pair of return springs 40.

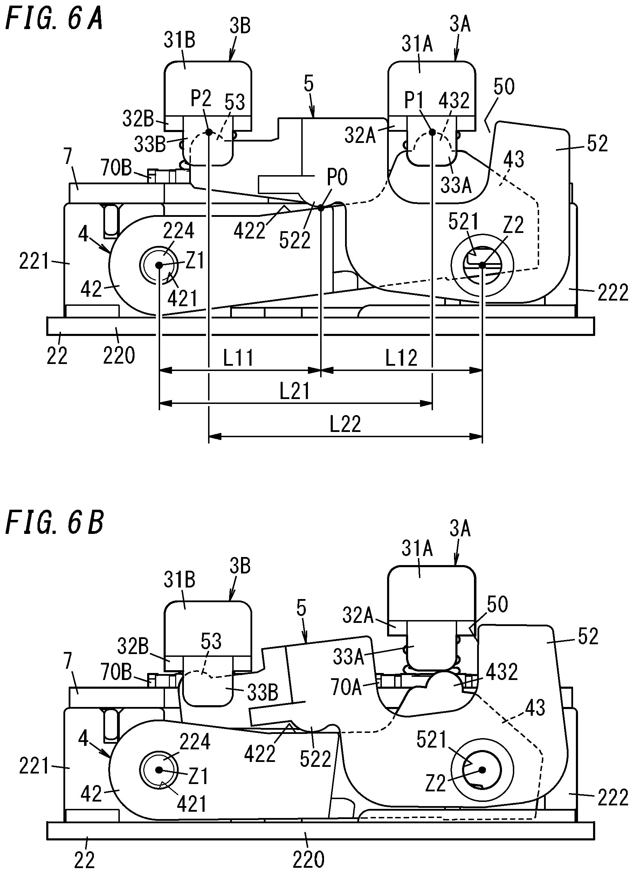

The second pivot member 5 is attached to an inner surface of the case 21. The second pivot member 5 is configured to pivot about a second pivot axis Z2 (see FIGS. 6A and 6B) along the forward/rearward direction in interconnection with the movement of the second operation section 3B. When the second pivot member 5 pivots, the second pressure receiving parts 422 are pushed, so that the first pivot member 4 pivots. That is, when the second operation section 3B is pushed, both the first pivot member 4 and the second pivot member 5 pivot. This enables the vibrator 61 to warp to vibrate.

Specifically, the second pivot member 5 includes a coupler 51, a pair of attachment pieces 52, and a pair of pressure receiving pieces 53.

The coupler 51 has a rectangular plate shape in plan view and couples the pair of attachment pieces 52 provided on both front and rear sides of the coupler 51. The coupler 51 is located between the substrate 7 and an upper inner surface of the case 21.

The pair of attachment pieces 52 are provided on both the front and rear sides of the coupler 51. The pair of attachment pieces 52 each have a plate shape having a thickness direction in the forward/rearward direction. The pair of attachment pieces 52 protrude downward from both front and rear ends of the second pivot member 5. The pair of attachment pieces 52 are provided on an outer side of the pair of holder pieces 43 of the first pivot member 4. Specifically, the pair of attachment pieces 52 are provided such that the pair of holder pieces 43 of the first pivot member 4 are located between the pair of attachment pieces 52 in the forward/rearward direction. The pair of attachment pieces 52 have through holes 521 which are circular and which penetrate the attachment pieces 52 in the forward/rearward direction. The case 21 has a pair of projections which are columnar and which are provided to both the front and rear inner surfaces of the case 21. The pair of projections provided to both the front and rear inner surfaces of the case 21 are fit in the pair of through holes 521 formed in the pair of attachment pieces 52, and thereby, the second pivot member 5 is attached to the case 21. The second pivot member 5 is configured to be pivotable about the second pivot axis Z2 which extends along the forward/rearward direction through the center of each of the pair of through holes 521.

Moreover, an opening section 50 extends along the forward/rearward direction over the coupler 51 and the pair of attachment pieces 52. The first operation section 3A is disposed on an inner side of the opening section 50. The first operation section 3A moves in the opening section 50 in the upward/downward direction to push the first pressure receiving parts 432 of the first pivot member 4.

The pair of pressure receiving pieces 53 protrude leftward from the left ends of the pair of attachment pieces 42. The pair of pressure receiving pieces 53 have tip ends (left ends) protruding upward. The tip ends of the pair of pressure receiving pieces 53 have upper surfaces which are curved and which are in contact with the pressing piece 32B of the second operation section 3B. When the second operation section 3B is pushed, the pair of pressure receiving pieces 53 receive downward force from the pressing piece 32B. Thus, the second pivot member 5 pivotably moves about the second pivot axis Z2 from the upper limit position to the lower limit position in the movable range. In the following description, the upper limit position of the second pivot member 5 in the movable range is referred to as a "second start position", and the lower limit position of the second pivot member 5 in the movable range is referred to as a "second end position" (see FIGS. 6A and 6B). The pair of pressure receiving pieces 53 are provided on an inner side of the pair of attachment pieces 42 of the first pivot member 4. Specifically, the pair of pressure receiving pieces 53 are located between the pair of attachment pieces 42 in the forward/rearward direction. Thus, when the pair of pressure receiving pieces 53 are pushed by the second operation section 3B and move downward, the pair of pressure receiving pieces 53 do not interfere with the pair of attachment pieces 42 of the first pivot member 4.

That is, when the second operation section 3B is pushed, the second pivot member 5 pivots about the second pivot axis Z2 in an anticlockwise direction when viewed in one of directions (from the front) along the second pivot axis Z2 (see FIGS. 6A and 6B).

Moreover, the second pivot member 5 further includes a pair of pressing parts 522. The pair of pressing parts 522 protrude downward from the left ends of the pair of attachment pieces 52 and have curved lower surfaces. The pair of pressing parts 522 are in contact with the pair of second pressure receiving parts 422 of the first pivot member 4. When the second pivot member 5 is pushed by the second operation section 3B and pivots, the pair of pressing parts 522 move downward. Thus, the pair of pressing parts 522 apply downward force to the pair of second pressure receiving parts 422 of the first pivot member 4. The first pivot member 4 pivots when the pair of second pressure receiving parts 422 receive the downward force. When the second operation section 3B is pushed, the first pivot member 4 is indirectly pushed via the second pivot member 5 and pivots, which will be described later in detail.

### (Operation)

The operation of the input apparatus 1 according to the present embodiment will be described below. First, power generation operation of the power generation device 6 will be described with reference to FIGS. 4A to 4C. FIG. 4A shows a state where the first pivot member 4 is in the first start position. FIG. 4B shows a state where the first pivot member 4 is at a location between the first start position and the first end position. FIG. 4C shows a state where the first pivot member 4 is in the first end position. Note that in FIGS. 4A to 4C, the case 21, the first operation section 3A, the second operation section 3B, the second pivot member 5, and the like are accordingly omitted.

As illustrated in FIG. 4A, when the first pivot member 4 is in the first start position, the magnetic weight 63 provided at the free end of the vibrator 61 is magnetically attracted to the magnet 44 held by the first pivot member 4.

When the first operation section 3A or the second operation section 3B is pushed, the first pivot member 4 pivots about the first pivot axis Z1 in a clockwise direction viewed from the front. As the first pivot member 4 pivots, the magnet 44 and the magnetic weight 63 magnetically attracted to the magnet 44 move downward (see FIG. 4B). That is, the vibrator 61 receives downward force at the free end (the right end) provided with the magnetic weight 63. Thus, the vibrator 61 is warped such that the free end (the right end) is located below the fixed end (the left end).

The vibrator 61 is warped, thereby coming into contact with the restriction piece 225 which extends through the through hole 411 formed in the bottom part 220 of the first pivot member 4 and which protrudes upward (see FIG. 4B). This restricts the lower limit position of the free end of the vibrator 61 in the movable range. In other words, the restriction piece 225 restricts the amount of warp of the vibrator 61.

As illustrated in FIG. 4C, when the first pivot member 4 moves to the first end position, the magnet 44 moves further downward. However, downward movement of the free end of the vibrator 61 is restricted by the restriction piece 225. Therefore, magnetic attraction between the magnet 44 and the magnetic weight 63 is released. That is, the downward force is no longer applied to the free end (the right end) of the vibrator 61. Thus, the vibrator 61 vibrates such that the free end (the right end) reciprocally moves in the upward/downward direction by the elastic force of the vibrator 61. The vibrator 61 vibrates, thereby repeatedly distorting the piezoelectric elements 62 provided to the vibrator 61, so that the elements 62 generate electric power.

When the force pushing the first operation section 3A or the second operation section 3B is released, the elastic force of the pair of return springs 40 moves the first pivot member 4 from the first end position to the first start position. The first pivot member 4 returns to the first start position, and thereby, the magnet 44 and the magnetic weight 63 are magnetically attracted to each other to stop vibration of the vibrator 61.

Thus, the first pivot member 4 pivots about the first pivot axis Z1 from the first start position (see FIG. 4A) to the first end position (see FIG. 4C), and thereby, the power generation device 6 generates electric power.

Next, operation when the first operation section 3A is pushed will be described with reference to FIGS. 5A and 5B. FIG. 5A shows a state where the first operation section 3A is not pushed, that is, in the reference position. FIG. 5B shows a state where the first operation section 3A is pushed, that is, in the operating position. Note that in FIGS. 5A and 5B, the case 21 and the like are accordingly omitted.

The first operation section 3A is at the upper end position (the reference position) in the movable range due to the elastic force of the first spring 30A in the steady state where the first operation section 3A is not pushed (see FIG. 5A). At this time, the first pivot member 4 is at the first start position due to the elastic force of the pair of return springs 40.

When the first operation section 3A is pushed, the pressing piece 32A applies downward force to the pair of first pressure receiving parts 432 of the first pivot member 4. When the downward force is applied to the pair of first pressure receiving parts 432, the first pivot member 4 pivots about the first pivot axis Z1 from the first start position (see FIG. 5A) to the first end position (see FIG. 5B). That is, when pushed, the first operation section 3A directly transmits, to the first pivot member 4, force that causes the first pivot member 4 to pivot. As used herein, "directly" indicates that force is transmitted from the first operation section 3A to the first pivot member 4 in a state where the first operation section 3A and the first pivot member 4 are in contact with each other. At this time, no force is transmitted from the first operation section 3A to the second pivot member 5, and therefore, the second pivot member 5 does not pivot, that is, remains at the second start position.

As described above, when the first operation section 3A is pushed, the downward force applied to the first operation section 3A is directly transmitted to the first pivot member 4. Thus, the first pivot member 4 pivots from the first start position to the first end position, and the power generation device 6 generates electric power (see FIGS. 4A to 4C).

In the present embodiment, the first operation section 3A applies force, from the pressing piece 32A, to the pair of first pressure receiving parts 432 aligned in the forward/rearward direction of the first pivot member 4. This enables the first pivot member 4 to stably pivot without tilting in the forward/rearward direction.

Next, operation when the second operation section 3B is pushed will be described with reference to FIGS. 6A and 6B. FIG. 6A shows a state where the second operation section 3B is not pushed, that is, in the reference position. FIG. 6B shows a state where the second operation section 3B is pushed, that is, in the operating position. Note that in FIGS. 6A and 6B, the case 21 and the like are accordingly omitted.

The second operation section 3B is at the upper end position (the reference position) in the movable range due to the elastic force of the second spring 30B in the steady state where the second operation section 3B is not pushed (see FIG. 6A). At this time, the first pivot member 4 is at the first start position due to the elastic force of the pair of return springs 40. Moreover, the pair of second pressure receiving parts 422 of the first pivot member 4 are in contact with the pair of pressing parts 522 of the second pivot member 5. Thus, the elastic force of the pair of return spring 40 is transmitted via the first pivot member 4 to the second pivot member 5. Thus, the second pivot member 5 is at the second start position which is the upper limit position in the movable range.

When the second operation section 3B is pushed, the pressing piece 32B applies downward force to the pair of pressure receiving pieces 53 of the second pivot member 5. When the downward force is applied to the pair of pressure receiving pieces 53, the second pivot member 5 pivots about the second pivot axis Z2 from the second start position (see FIG. 6A) to the second end position (see FIG. 6B). Moreover, when the second pivot member 5 pivots, the pair of pressing parts 522 apply downward force to the pair of second pressure receiving parts 422 of the first pivot member 4. When the downward force is applied to the pair of second pressure receiving parts 422, the first pivot member 4 pivots about the first pivot axis Z1 from the first start position (see FIG. 6A) to the first end position (see FIG. 6B).

That is, when pushed, the second operation section 3B indirectly transmits, via the second pivot member 5 to the first pivot member 4, force that causes the first pivot member 4 to pivot. Therefore, when the second operation section 3B is pushed, both the first pivot member 4 and the second pivot member 5 pivot.

As described above, when the second operation section 3B is pushed, the downward force applied to the second operation section 3B is indirectly transmitted via the second pivot member 5 to the first pivot member 4. Thus, the first pivot member 4 pivots from the first start position to the first end position, and the power generation device 6 generates electric power (see FIGS. 4A to 4C).

In the present embodiment, the second operation section 3B applies force, from the pressing piece 32B, to the pair of pressure receiving pieces 53 aligned in the forward/rearward direction of the second pivot member 5. This enables the second pivot member 5 to stably pivot without tilting in the forward/rearward direction. Moreover, the second pivot member 5 applies force from the pair of pressing parts 522 aligned in the forward/rearward direction to the pair of second pressure receiving parts 422 aligned in the forward/rearward direction of the first pivot member 4. This enables the first pivot member 4 to stably pivot without tilting in the forward/rearward direction.

Next, force (operation force) that pushes the first operation section 3A and the second operation section 3B will be described.

In the following description, force that pushes the first operation section 3A and that is necessary to cause the first pivot member 4 to pivot from the first start position to the first end position is referred to as "first operation force". Moreover, force that pushes the second operation section 3B and that is necessary to cause the first pivot member 4 to pivot from the first start position to the first end position is referred to as "second operation force".

The present embodiment is configured such that the first operation section 3A directly applies force to the first pivot member 4 and the second operation section 3B indirectly applies force via the second pivot member 5 to the first pivot member 4. Thus, the first operation force and the second operation force can be adjusted by adjusting the positional relationship among the first operation section 3A, the second operation section 3B, the first pivot member 4, and the second pivot member 5.

Specifically, as described above, the direction in which the first pivot member 4 pivots from the first start position to the first end position (the clockwise direction viewed from the front) is opposite to the direction in which the second pivot member 5 pivots from the second start position to the second end position (the anticlockwise direction when viewed from the front). The pair of second pressure receiving parts 422 of the first pivot member 4 come into contact with the pair of pressing parts 522 of the second pivot member 5 at contact points P0 located between the first pivot axis Z1 and the second pivot axis Z2 in the rightward/leftward direction. Moreover, between the first pivot axis Z1 and the second pivot axis Z2 in the rightward/leftward direction, contact points P1 and contact points P2 are located. The contact points P1 are contact points at which the pair of first pressure receiving parts 432 of the first pivot member 4 come into contact with the pressing piece 32A of the first operation section 3A. The contact points P2 are contact points at which the pair of pressure receiving pieces 53 of the second pivot member 5 come into contact with the pressing piece 32B of the second operation section 3B. Moreover, each contact point P0 of the first pivot member 4 and the second pivot member 5 is located between a corresponding one of the contact points P1 of the first pivot member 4 and the first operation section 3A and a corresponding one of the contact points P2 of the second pivot member 5 and the second operation section 3B in the rightward/leftward direction.

That is, the first pivot axis Z1 of the first pivot member 4 is located on one side (on the left side) of the contact points P0 in the rightward/leftward direction, and the contact points P1 of the first pivot member 4 and the first operation section 3A are located on the other side (the right side) of the contact points P0 in the rightward/leftward direction. Moreover, the contact points P2 of the second pivot member 5 and the second operation section 3B are located on one side (on the left side) of the contact points P0 in the rightward/leftward direction, and the second pivot axis Z2 of the second pivot member 5 is located on the other side (the right side) of the contact points P0 in the rightward/leftward direction.

In the rightward/leftward direction, the distance from each contact point P0 of the first pivot member 4 and second pivot member 5 to the first pivot axis Z1 of the first pivot member 4 is L11. In the rightward/leftward direction, the distance from each contact point P0 of the first pivot member 4 and second pivot member 5 to the second pivot axis Z2 of the second pivot member 5 is L12. In the rightward/leftward direction, the distance from the first pivot axis Z1 of the first pivot member 4 to each contact point P1 of the first pivot member 4 and the first operation section 3A is L21. In the rightward/leftward direction, the distance from the second pivot axis Z2 of the second pivot member 5 to each contact point P2 of the second pivot member 5 and the second operation section 3B is L22.

Adjusting the distances L11, L12, L21, and L22 enables the moment of force when the first operation section 3A and the second operation section 3B are pushed to be adjusted. Thus, adjusting the distances L11, L12, L21, and L22 enables the difference between the first operation force which gives a push operation to the first operation section 3A and the second operation force which gives a push operation to the second operation section to be reduced.

In the present embodiment, the distances L11, L12, L21, and L22 are adjusted as described below so that the first operation force and the second operation force are equal to each other. However, "equal" as used herein includes not only a strictly equal state but also a substantially equal state within a certain number of errors.

The present embodiment is configured such that the distance L11 between each contact point P0 and the first pivot axis Z1 and the distance L12 between each contact point P0 and the second pivot axis Z2 in the rightward/leftward direction are equal to each other. Moreover, in the rightward/leftward direction, the distance L21 between the first pivot axis Z1 and each contact point P0 and the distance L22 between the second pivot axis Z2 and each contact point P2 are equal to each other.

With the configuration described above, the moment of force that pushes the first operation section 3A to cause the first pivot member 4 to pivot from the first start position to the first end position and the moment of force that pushes the second operation section 3B to cause the first pivot member 4 to pivot from the first start position to the first end position balance each other. Thus, the first operation force and the second operation force are equal to each other.

Note that adjusting the magnitude relationship between the distance L11 and the distance L12 and the magnitude relationship between the distance L21 and the distance L22 enables one operation force to be adjusted to be greater (or less) than the other operation force.

Next, a click rate when the operation section (the first operation section 3A, the second operation section 3B) is pushed will be described. The click rate is a ratio of the operation force before and after the operation force drastically changes in the course of pushing the operation sections. As described above, the first operation force and the second operation force are substantially equal to each other, and a click rate when the first operation section 3A is pushed and a click rate when the second operation section 3B is pushed are substantially equal to each other. Thus, in this embodiment, the click rate when the first operation section 3A is pushed will be described, and the description of the click rate when the second operation section 3B is pushed will be omitted.

When the magnet 44 and the magnetic weight 63 are magnetically attracted to each other (see FIG. 4B), the first operation force is mainly determined by the elastic force of the pair of return springs 40, the elastic force of the first spring 30A, and the elastic force of the vibrator 61. In this embodiment, magnetic attraction force between the magnet 44 and the magnetic weight 63 is ignored. When magnetic attraction between the magnet 44 and the magnetic weight 63 is released (see FIG. 4C), the first operation force is mainly determined by the elastic force of the pair of return springs 40 and the elastic force of the first spring 30A. That is, when the magnetic attraction between the magnet 44 and the magnetic weight 63 is released, the first operation force no longer includes the elastic force of the vibrator 61, and therefore, the first operation force rapidly decreases. Thus, the presence or absence of the elastic force of the vibrator 61 in the first operation force results in a clicking feeling.

The present embodiment is configured such that each of the elastic force of the pair of return spring 40 and the elastic force of the first spring 30A is less than the elastic force of the vibrator 61. This enables the click rate to be increased.

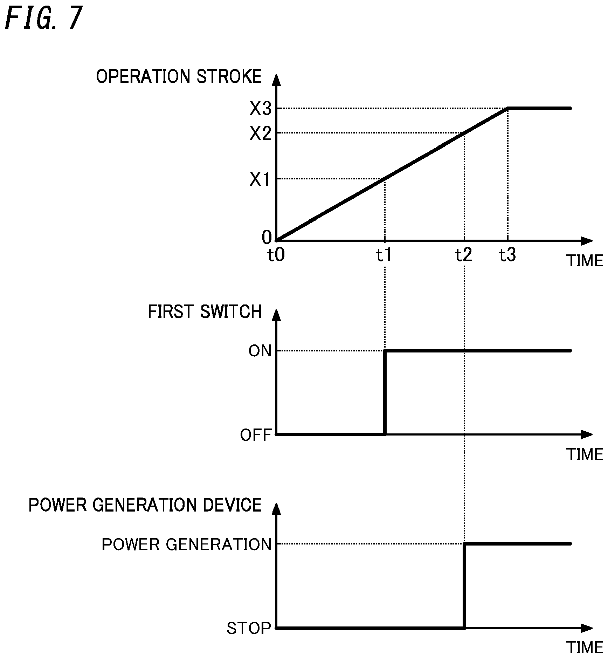

Next, a relationship between a timing at which a switch (the first switch 70A, the second switch 70B) is turned ON and a timing at which the power generation device 6 starts generating electric power when the operation section (the first operation section 3A, the second operation section 3B) is pushed will be described with reference to FIG. 7. The relationship between the timing at which the first switch 70A is turned ON and the timing at which the power generation device 6 starts generating electric power when the first operation section 3A is pushed is the same as the relationship between the timing at which the second switch 70B is turned ON and the timing at which the power generation device 6 starts generating electric power when the second operation section 3B is pushed. Thus, in the present embodiment, a description is given of only the relationship between the timing at which the first switch 70A is turned ON and the timing at which the power generation device 6 starts generating electric power when the first operation section 3A is pushed.

The first spring 30A is disposed between the first switch 70A and the first operation section 3A. When the first operation section 3A is pushed, the first spring 30A compresses, and downward force applied to the first operation section 3A is transmitted via the first spring 30A to the first switch 70A, and the first switch 70A is thus turned ON. Thus, adjusting the elastic force of the first spring 30A enables the timing at which the first switch 70A is turned ON when the first operation section 3A is pushed to be adjusted.

In the present embodiment, the elastic force of the first spring 30A is set such that when the first switch 70A is pushed, the first switch 70A is turned ON at a timing before the power generation device 6 starts generating electric power. Specifically, the elastic force of the first spring 30A is set such that the first switch 70A is turned ON with an operation stroke of the first operation section 3A being a stroke shorter than a stroke that causes the power generation device 6 to start generating electric power.

As illustrated in FIG. 7, when the first operation section 3A is pushed, the operation stroke of the first operation section 3A increases over time. It is assumed that at a time point t0, pushing force is started to be applied to the first operation section 3A. At the time point t0, the operation stroke of the first operation section 3A is zero, and the first pivot member 4 is at the first start position (see FIG. 4A).

Then, at a time point t2, the operation stroke of the first operation section 3A is X2, and the vibrator 61 of the power generation device 6 comes into contact with the restriction piece 225 (see FIG. 4B). When the first operation stroke exceeds X2, the magnetic attraction between the magnet 44 and the magnetic weight 63 is released, and the vibrator 61 vibrates, that is, the power generation device 6 starts generating electric power. At a time point t3, the operation stroke of the first operation section 3A is X3 which is the upper limit, and the first pivot member 4 is at the first end position (see FIG. 4C).

The elastic force of the first spring 30A is set such that the first switch 70A is turned ON with the operation stroke of the first operation section 3A being X1 which is shorter than X2. Thus, the first switch 70A is turned ON at a time point t1 before the time pint t2 at which the power generation device 6 starts generating electric power.

As described above, the present embodiment is configured such that, when the first operation section 3A is pushed, the first switch 70A is turned ON before the timing at which the power generation device 6 starts generating electric power. Similarly, when the second operation section 3B is pushed, the second switch 70B is turned ON before the timing at which the power generation device 6 starts generating electric power.

In the case of a configuration that the switch is turned ON after the power generation device 6 starts generating electric power, the switch may be OFF at a time point at which the control circuit 72 provided to the substrate 7 is activated if a time for which the operation section is pushed decreases. In this case, the control circuit 72 can no longer determine which operation section of the first operation section 3A or the second operation section 3B is pushed.

The present embodiment is configured such that the first switch 70A or the second switch 70B is turned ON before the power generation device 6 starts generating electric power. Thus, at the timing at which the power generation device 6 starts generating electric power, the first switch 70A or the second switch 70B is in the ON state. That is, when the control circuit 72 provided to the substrate 7 is activated, the first switch 70A or the second switch 70B is in the ON state. Thus, the control circuit 72 can determine which operation section of the first operation section 3A or the second operation section 3B is pushed, and the control circuit 72 can cause a transmission circuit to output a radio signal corresponding to the operation section which is pushed.

### (Variation)

### (First Variation)

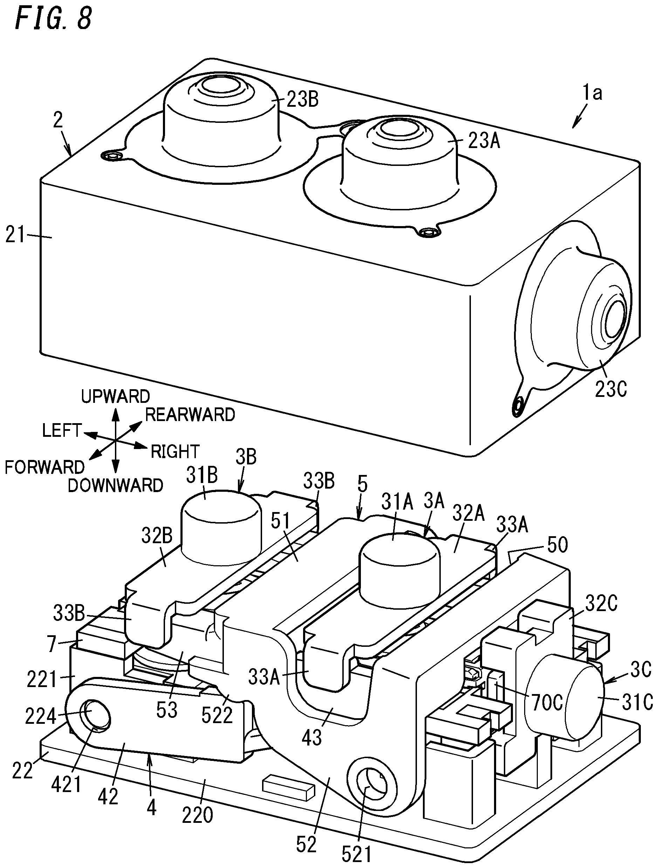

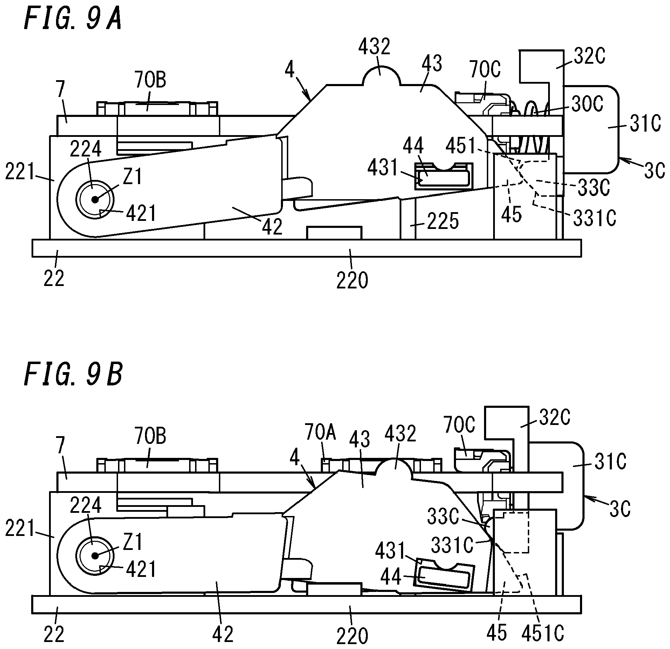

Next, an input apparatus 1a according to a first variation will be described with reference to FIGS. 8, 9A, and 9B.

The input apparatus 1a of the present variation is different from the input apparatus 1 of the embodiment described above in that a third operation section 3C is provided in addition to the first operation section 3A and the second operation section 3B. In the following description of the input apparatus 1a of the present variation, the difference from the input apparatus 1 of the embodiment described above will be mainly described, and components similar to those of the embodiment described above will be denoted by the same reference signs as those in the embodiment described above, and the description thereof will be omitted.

The first operation section 3A and the second operation section 3B are configured to be pushed downward, whereas the third operation section 3C is configured to be pushed leftward.

The third operation section 3C is made of a synthetic resin. The third operation section 3C includes a projection 31C, a flange 32C, and a pressing part 33C. The flange 32C has a rectangular plate shape having a thickness direction in the rightward/leftward direction. The projection 31C has a columnar shape protruding rightward from a central part of a right surface of the flange 32C. The pressing part 33C protrudes leftward from a lower end of the flange 32C. The pressing part 33C has a tilted surface 331C which tilts upward as the distance from the flange 32C increases.

The third operation section 3C is incorporated into a case 21 such that the projection 31C extends from a left side through a through hole formed in a right surface of the case 21. Thus, a tip end (an upper end) of the projection 31C passes through the through hole and protrudes leftward from an upper surface of a housing 2.

On the right surface of the case 21, a waterproof rubber member 23C is provided at a peripheral portion of the through hole through which the projection 31C extends. The waterproof rubber member 23C has the same configuration as each of the waterproof rubber members 23A and 23B and covers the projection 31C and the through hole through which the projection 31C extends.

The housing 2 accommodates a third switch 70C and a third spring 30C corresponding to the third operation section 3C.

The third switch 70C is located on the left of the projection 31C of the third operation section 3C. The third switch 70C is mounted on a substrate 7 with an operation surface thereof being a right surface. The third spring 30C is disposed between the projection 31C and the third switch 70C.

The third operation section 3C linearly moves between the reference position and the operating position along the leftward/rightward direction in accordance with an operation given by a user. When the third operation section 3C is at the reference position, that is, in the steady state, the third switch 70C is OFF, and when the third operation section 3C is at the operating position, the third switch 70C is ON. Thus, the third operation section 3C and the third switch 70C form a momentary-type push button switch, that is, the third switch 70C is in an ON state only while the third operation section 3C is pushed.

The input apparatus 1a of the present variation includes a first pivot member 4 having a third pressure receiving part 45. The third pressure receiving part 45 protrudes rightward from a bottom part 41 of the first pivot member 4 (see FIGS. 9A and 9B). The third pressure receiving part 45 has a tilted surface 451 tilted in the rightward/leftward direction to face a tilted surface 331C of the pressing part 33C of the third operation section 3C. The tilted surface 451 of the third pressure receiving part 45 is in contact with the tilted surface 331C of the pressing part 33C.

Operation when the third operation section 3C is pushed will be described below with reference to FIGS. 9A and 9B. FIG. 9A shows a state where the third operation section 3C is not pushed, that is, in the reference position. FIG. 9B shows a state where the third operation section 3C is pushed, that is, in the operating position. Note that in FIGS. 9A and 9B, the case 21, the first operation section 3A, the second operation section 3B, a second pivot member 5, and the like are accordingly omitted.

The third operation section 3C is at a right end (i.e., at the reference position) in the movable range due to the elastic force of the third spring 30C in the steady state where the third operation section 3C is not pushed (see FIG. 9A). At this time, the first pivot member 4 is at the first start position due to the elastic force of a pair of return springs 40.

When the third operation section 3C is then pushed leftward, leftward force applied to the third operation section 3C is converted by the tilted surface 331C of the pressing part 33C and the tilted surface 451 of the third pressure receiving part 45 into downward force, and the downward force is transmitted to the first pivot member 4. Thus, the first pivot member 4 pivots about a first pivot axis Z1 from a first start position (see FIG. 9A) to a first end position (see FIG. 9B). That is, when pushed, the third operation section 3C directly transmits, to the first pivot member 4, force that causes the first pivot member 4 to pivot. The first pivot member 4 pivots from the first start position to the first end position, and thereby, a power generation device 6 generates electric power.

Moreover, when the third operation section 3C is pushed, the elastic force of the third spring 30C is set such that the third switch is turned ON before a timing at which the power generation device 6 starts generating electric power in a similar manner to the case where the first operation section 3A or the second operation section 3B is pushed.

Moreover, force which pushes the third operation section 3C and which is necessary to cause the first pivot member 4 to pivot from the first start position to the first end position is referred to as "third operation force". The third operation force is adjustable by tilt angles of the tilted surface 331C of the pressing part 33C and the tilted surface 451 of the third pressure receiving part 45. Thus, adjusting the tilt angles of the tilted surface 331C of the pressing part 33C and the tilted surface 451 of the third pressure receiving part 45 can make the magnitudes of the first operation force, the second operation force, and the third operation force equal to one another.

Note that in the present variation, the third operation section 3C is configured to directly apply force to the first pivot member 4 to cause the first pivot member 4 to pivot, but this configuration should not be construed as limiting. The third operation section 3C may be configured to indirectly apply force to the first pivot member 4 to cause the first pivot member 4 to pivot. For example, the third operation section 3C may be configured to indirectly apply force via the second pivot member 5 to the first pivot member 4 to cause the first pivot member 4 to pivot.

Moreover, in the present variation, the third operation section 3C is configured to be pushed leftward, but the direction in which the third operation section 3C is pushed is not limited to the leftward direction, and the third operation section 3C may be configured to be pushed rightward, forward, rearward or the like. For example, the third operation section 3C may be configured to be pushed rightward and may be configured to apply force via the second pivot member 5 to the first pivot member 4 to cause the first pivot member 4 to pivot.

### (Second Variation)

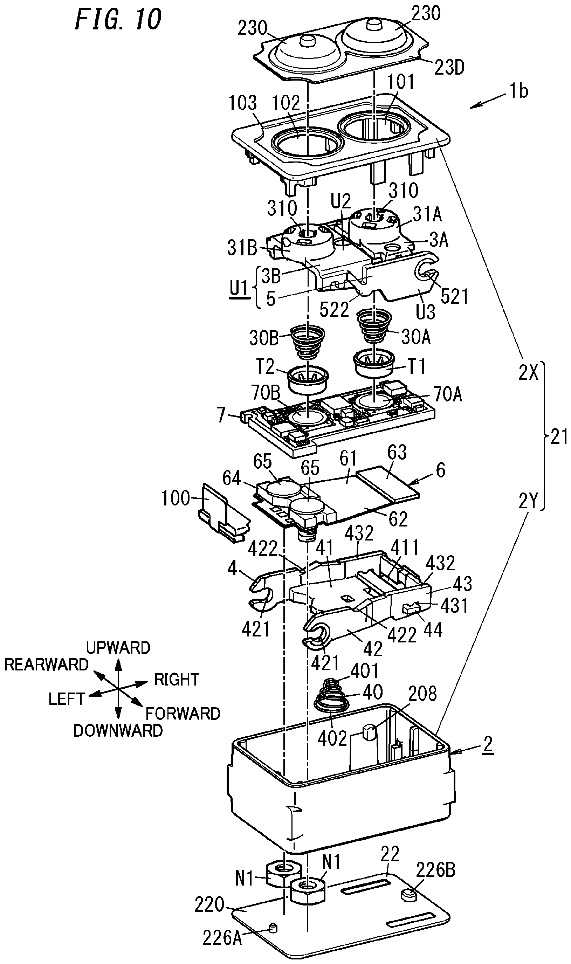

Next, an input apparatus 1b according to a second variation will be described with reference to FIGS. 10 to 18B. The input apparatus 1b of the present variation is different from the input apparatus 1 of the embodiment described above mainly in the following first to fourth differences. In the following description of the input apparatus 1b, components having substantially the same functions or structures as those of the input apparatus 1 of the embodiment described above are denoted by the same reference signs as much as possible, and the description thereof may be omitted.

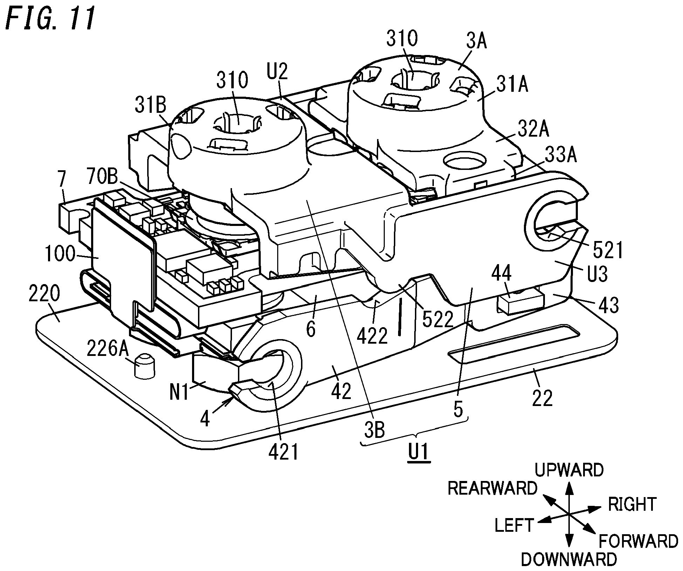

The first difference is that a case 21 of a housing 2 is divided into an upper cover 2X and a case body 2Y (see FIG. 10). The second difference is that a second operation section 3B is integrated with a second pivot member 5 (see FIG. 10). The third difference is that the input apparatus 1b includes a first cover part T1 and a second cover part T2 respectively covering a first spring 30A and a second spring 30B (see FIG. 10). The fourth difference is that a Flexible Printed Circuits (FPC) 100 is provided in place of the pair of first contact point springs 67 and the pair of second contact point springs 68 for electrically connecting a piezoelectric element 62 to a substrate 7 (FIGS. 10 and 11). The input apparatus 1b will be described in further detail below.

### [First Difference]

The housing 2 of the input apparatus 1b is made of a synthetic resin and is in the form of a rectangular parallelepiped. In the input apparatus 1b, the case 21 of the housing 2 is divided into the upper cover 2X and the case body 2Y as described above. In other words, the housing 2 includes the upper cover 2X, the case body 2Y, and a lower cover 22.

The upper cover 2X has a substantially plate shape which is rectangular. The upper cover 2X has a lower surface provided with a plurality of insertion pieces protruding downward. The upper cover 2X is positioned by inserting the plurality of insertion pieces into the case body 2Y.

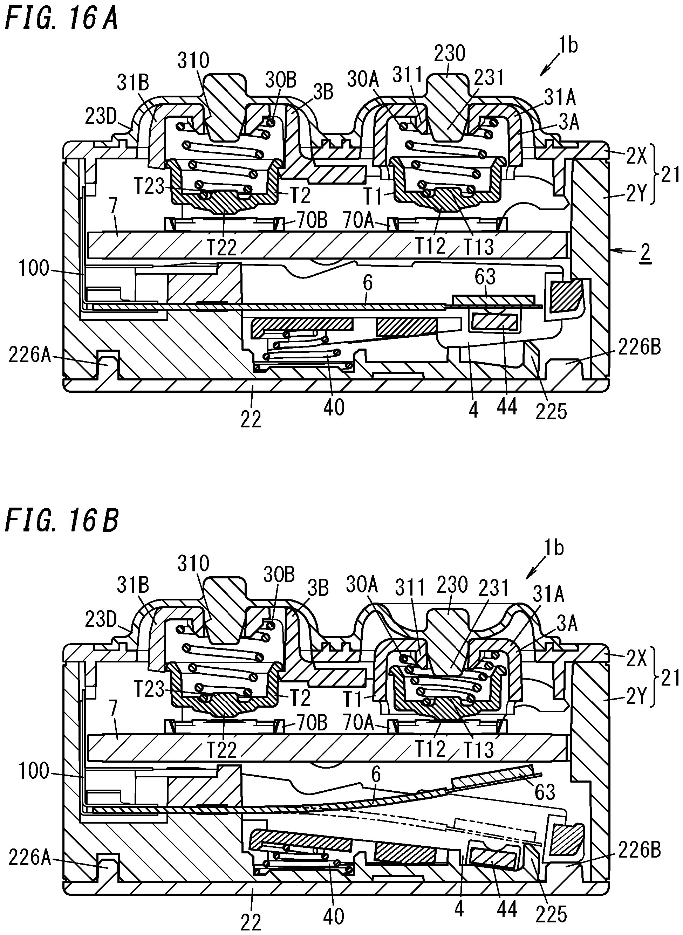

As illustrated in FIG. 10, the upper cover 2X has: a through hole 101 through which a projection 31A of a first operation section 3A extends; and a through hole 102 through which a projection 31B of a second operation section 3B extends. The input apparatus 1b includes a waterproof rubber member 23D disposed on an upper surface of the upper cover 2X. The waterproof rubber member 23D has a substantially rectangular plate shape as a whole and has a pair of dome parts 230 each of which is convex in the form of a dome and which are aligned in the rightward/leftward direction. The waterproof rubber member 23D is attached to the upper surface of the upper cover 2X by, for example, being fit in a positioning groove 103 which is recessed downward in the upper surface of the upper cover 2X to surround the through hole 101 and the through hole 102, and the waterproof rubber member 23D covers the through hole 101 and the through hole 102. In the attached state, a pair of projections 231 (see FIGS. 16A and 16B) protruding downward on inner sides of the pair of dome parts 230 of the waterproof rubber member 23D are inserted into and fixed to a pair of pores 310 each of which is formed in a corresponding one of the projection 31A and the projection 31B. As a result, the waterproof rubber member 23D is positioned with respect to the projection 31A and the projection 31B.

The waterproof rubber member 23D is sufficiently flexible so as to be able to individually push the first operation section 3A and the second operation section 3B via the pair of dome parts 230.

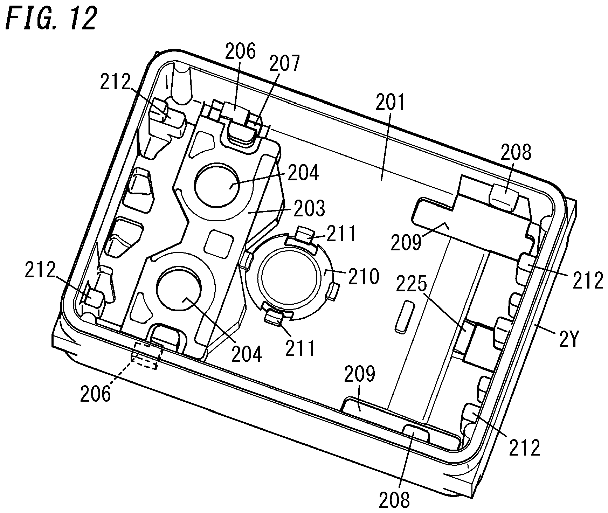

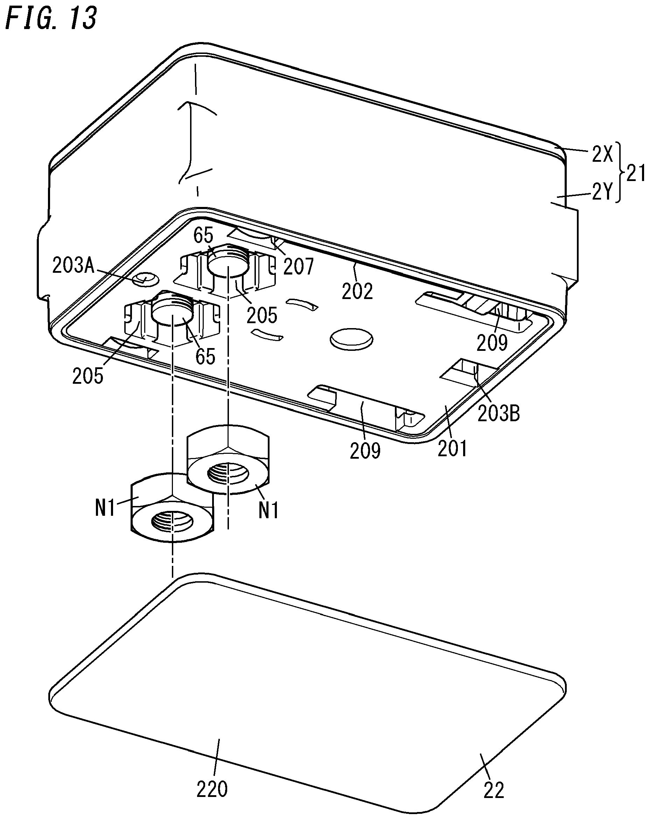

The case body 2Y has a rectangular box shape whose upper surface is an opening. The upper cover 2X is attached to close the opening of the case body 2Y. As illustrated in FIGS. 12 and 13, the case body 2Y has a bottom part 201. The bottom part 201 is provided at a location slightly higher than a lower peripheral portion of the case body 2Y. In other words, the case body 2Y has a lower surface having a recess 202 (see FIG. 13) in which the lower cover 22 is to be fit.

As illustrated in FIG. 12, the bottom part 201 has a projection base 203 which is provided near a left end of an upper surface thereof and which protrudes upward in the form of a block. The projection base 203 has a pair of through holes 204 in which a pair of attachment screws 65 are to be inserted. Each through hole 204 penetrates the bottom part 201 in the thickness direction thereof.

Moreover, as illustrated in FIG. 13, the bottom part 201 has a pair of nut accommodation parts 205 which are provided near a left end of a lower surface thereof and each of which is recessed in a hexagonal form to surround a corresponding one of the through holes 204. Each of a pair of hex nuts N1 is accommodated in a corresponding one of the pair of nut accommodation parts 205 from a lower side of the case body 2Y. In a state where the pair of hex nuts N1 are accommodated in the pair of nut accommodation parts 205, the attachment screws 65 extending through the through holes formed in a vibrator 61 are each screwed into a corresponding one of the hex nuts N1 through the bottom part 201 from an upper side of the bottom part 201, thereby fixing a power generation device 6 to the case body 2Y.

As illustrated in FIG. 12, the case body 2Y has front and rear side surfaces on an inner side thereof which are provided with a pair of projections 206 configured to pivotably support the first pivot member 4. The pair of projections 206 protrude from leftward locations of the front and rear side surfaces in a direction in which they approach each other. The bottom part 201 has a pair of clearance holes 207 which face the pair of projections 206 and which are for avoiding interference with parts of the first pivot member 4.

As illustrated in FIG. 12, the case body 2Y includes a pair of projections 208 on the front and rear side surfaces on the inner side thereof, and the pair of projections 208 are configured to pivotably support the second pivot member 5. The pair of projections 208 protrudes from rightward locations of the front and rear side surfaces in a direction in which they approach each other. The bottom part 201 has a pair of clearance holes 209 which face the pair of projections 208 and in which parts of the second pivot member 5 are to be let when the second pivot member 5 pivots.

The lower cover 22 has a bottom part 220 which has a rectangular plate shape. As illustrated in FIG. 10, the lower cover 22 includes a small projection 226A and a large projection 226B protruding upward and respectively provided near left and right ends of an upper surface of the bottom part 220. The lower cover 22 is positioned by inserting, from the lower side of the case body 2Y, the small projection 226A and the large projection 226B respectively into a small pore 203A and a large pore 203B (see FIG. 13) formed in the bottom part 201.

The upper cover 2X is connected to a peripheral portion of the opening of the case body 2Y, and the lower cover 22 is connected to a lower peripheral portion of the case body 2Y, thereby forming the housing 2.

### [Second Difference]

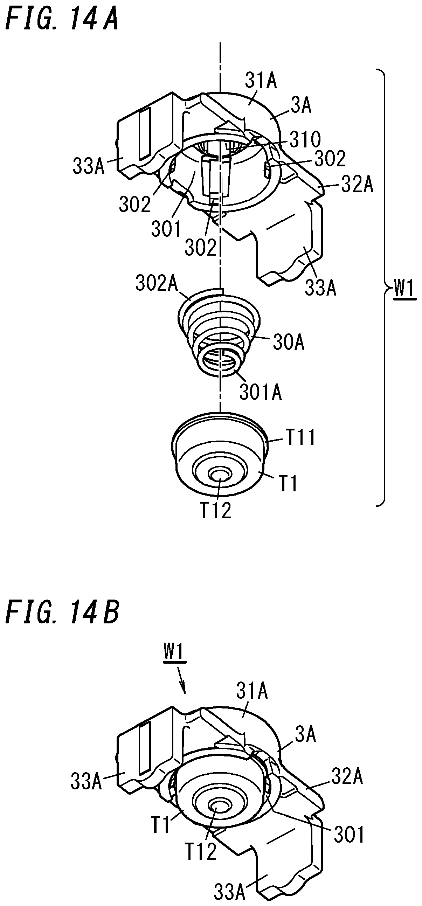

The first operation section 3A is made of a synthetic resin. As illustrated in FIGS. 10, 14A, and 14B, the first operation section 3A includes the projection 31A, a pressing piece 32A, and a pair of protruding pieces 33A. The first operation section 3A of the input apparatus 1b is generally larger than the first operation section 3A of the input apparatus 1 described above. In particular, the projection 31A of the input apparatus 1b protrudes from the pressing piece 32A and has a hollow cylinder shape having an opening on a lower surface thereof. An internal space of the projection 31A corresponds to an accommodation recess 301 which accommodates, together with the first cover part T1 described later, the first spring 30A. In other words, the first operation section 3A has the accommodation recess 301 which is formed in a lower surface thereof and which is recessed upward. The accommodation recess 301 is communicated with the pore 310 of the projection 31A.

The first operation section 3A includes a plurality of pawls 302 at a lower portion of an inner peripheral surface of the accommodation recess 301, and the first cover part T1 is hooked on the plurality of pawls 302 so that the plurality of pawls hold the first cover part T1. The plurality of pawls 302 protrude toward the central axis of the accommodation recess 301.

The second operation section 3B is integrated with the second pivot member 5 as described above. In other words, the input apparatus 1b includes an operation block body U1 which is a single molded product formed by integrating the second operation section 3B and the second pivot member 5 with each other. Thus, in the present variation, the number of components can be reduced, and cost can thus be reduced. The operation block body U1 is made of a synthetic resin.

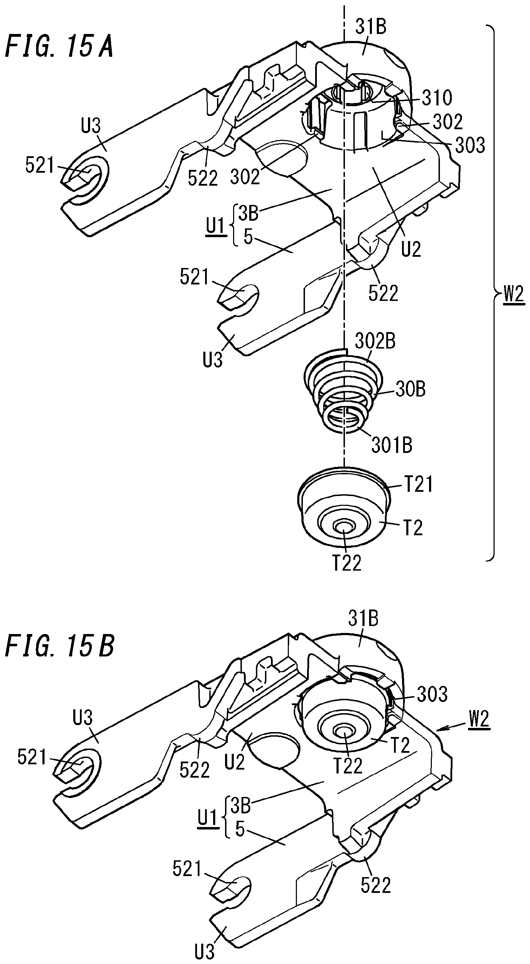

Specifically, the operation block body U1 includes the projection 31B, a base U2, and a pair of arms U3 as illustrated in FIGS. 10, 15A, and 15B. The projection 31B corresponds to a component of the second operation section 3B, the pair of arms U3 correspond to components of the second pivot member 5, and the base U2 serves as components of both the second operation section 3B and the second pivot member 5.

The base U2 has a rectangular plate shape elongated in the forward/rearward direction. The projection 31B protrudes from the base U2 and has a hollow cylinder shape having an opening in a lower surface thereof. An internal space of the projection 31B corresponds to an accommodation recess 303 which accommodates, together with the second cover part T2 described later, the second spring 30B. In other words, the second operation section 3B has the accommodation recess 303 which is formed in the lower surface of the second operation section 3B and which is recessed upward. The accommodation recess 303 is communicated with the pore 310 of the projection 31B.

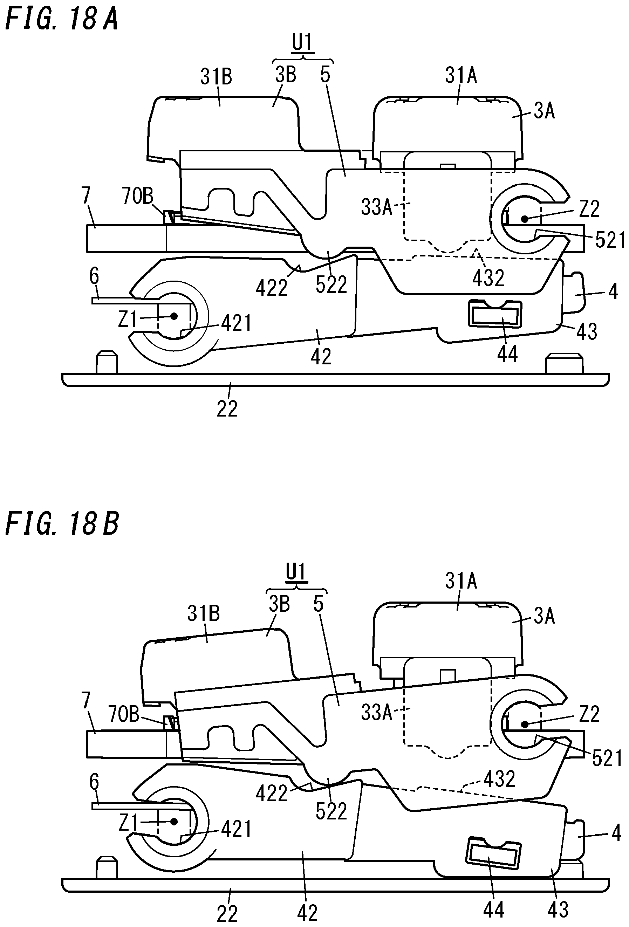

The pair of arms U3 are integrated with protruding pieces protruding downward from both front and rear ends of the base U2 and extend rearward from the base U2. The pair of arms U3 are provided on an outer side of a pair of holder pieces 43 of the first pivot member 4 and face attachment pieces 42 on an outer side of the holder pieces 43 of the first pivot member 4. Moreover, the first operation section 3A is disposed on an inner side of the pair of arms U3. Each arm U3 has a pressing part 522 at a location shifted slightly forward from the center thereof in the forward/rearward direction. In other words, the second pivot member 5 of the operation block body U1 has the pair of pressing parts 522 which come into contact with a pair of second pressure receiving parts 422 of the first pivot member 4 in a similar manner to the second pivot member 5 of the input apparatus 1 of the embodiment described above. Moreover, each of the arms U3 has a through hole 521 which is circular and which penetrates a corresponding one of the arms U3 in the forward/rearward direction. Note that each through hole 521 has a right edge portion which is open, and each arm U3 has a right end which is substantially C-shaped when viewed along the forward/rearward direction. The projections 208 of the case body 2Y are fit in the respective through holes 521, thereby attaching the operation block body U1 to the case 21. The operation block body U1 is configured to be pivotable about the second pivot axis Z2 (see FIGS. 18A and 18B) which extends along the forward/rearward direction through the center of each of the pair of through holes 521.

In a similar manner to the input apparatus 1 of the embodiment described above, a first switch 70A, a second switch 70B, electronic components forming a power supply circuit 71, a control circuit 72, a transmission circuit 73, and the like are mounted on the substrate 7 of the input apparatus 1b. The substrate 7 is stably mounted on a plurality of support ribs 212 (see FIG. 12) provided on left and right inner side surfaces of the case body 2Y. Also in the input apparatus 1b, when the first operation section 3A or the second operation section 3B is pushed, the power generation device 6 generates electric power. Then, electric power generated by the power generation device 6 is used to output a radio signal according to the operation section of the first operation section 3A or the second operation section 3B which is pushed.

### [Third Difference]

The input apparatus 1b further includes the first cover part T1 and the second cover part T2 as described above.

In this variation, as described in FIGS. 14A and 14B, the first operation section 3A, the first cover part T1, and the first spring 30A form a first operation structural component W1. Moreover, as illustrated in FIGS. 15A and 15B, the operation block body U1, the second cover part T2, and the second spring 30B form a second operation structural component W2.

First, the first operation structural component W1 will be described in detail with reference to FIGS. 14A and 14B.

The first spring 30A is a circular cone coil spring. The first spring 30A has a first end 301A having a small diameter dimension and a second end 302A having a large diameter dimension. The first spring 30A is disposed with the first end 301A facing downward.

The first cover part T1 (an actuator), together with the first operation section 3A, encloses the first spring 30A. The first cover part T1 as a whole has a bowl shape with an upper surface being open. The first cover part T1 is made of, for example, a polyoxymethylene (POM) resin having relatively satisfactory wear resistance and slidability. The first cover part T1 has a flange part T11 which protrudes outward over the entire peripheral portion of the upper surface which is open. The flange part T11 is a part to be hooked on the plurality of pawls 302 of the first operation section 3A.

Moreover, the first cover part T1 has a contact T12 at a central part of a lower surface thereof, and the contact T12 stepwise protrudes toward the first switch 70A. The contact T12 is a part that comes into contact with the first switch 70A which the contact T12 faces.

The first cover part T1 can accommodate part (a lower half part) of the first spring 30A from the upper surface, which is open. Note that a remaining part (an upper half part) of the first spring 30A is accommodated in the accommodation recess 301 of the first operation section 3A. The first cover part T1 has a support projection T13 (see FIG. 16A) on a bottom surface on an inner side thereof, and the support projection T13 protrudes toward the projection 31A. The support projection T13 is inserted into the first end 301A of the first spring 30A, and thereby, the first spring 30A is stably held in the interior of the first cover part T1. The accommodation recess 301 of the first operation section 3A is provided with a cylindrical part 311 (see FIG. 16A) protruding downward from a peripheral portion of the pore 310. The cylindrical part 311 is inserted into the second end 302A of the first spring 30A, and thereby, the first spring 30A is stably held in the accommodation recess 301 of the first operation section 3A.

The first cover part T1 having such a configuration is held by the first operation section 3A by the flange part T11 being hooked on the plurality of pawls 302 of the first operation section 3A while accommodating the first spring 30A in a slightly compressed state with respect to the equilibrium length of the first spring 30A. In other words, the first cover part T1 is held by the first operation section 3A to cover the first spring 30A. The first switch 70A is disposed under the first cover part T1.

The first operation section 3A is fixed by inserting the projection 231 on the right side of the waterproof rubber member 23D into the pore 310 of the projection 31A. In other words, the first operation structural component W1 is held by the waterproof rubber member 23D. Thus, the first operation section 3A is, together with the dome part 230 on the right side, at an upper end position in the movable range in the steady state where the first operation section 3A is not pushed. The position of the first operation section 3A at this time is referred to as a "reference position" in the following description. When the first operation section 3A is at the reference position, the first switch 70A is OFF. Note that when the first operation section 3A is in the reference position, a gap may be provided between the first cover part T1 and the first switch 70A, or the first cover part T1 may be in direct contact with the first switch 70A.

The first operation section 3A moves downward from the reference position in a state where the first operation section 3A is pushed, and the contact T12 of the first cover part T1 comes into contact with the first switch 70A. At this time, downward force applied to the first operation section 3A is transmitted via the first spring 30A and the first cover part T1 to the first switch 70A. The position of the first operation section 3A at this time is referred to as an "operating position" in the following description. When the first operation section 3A is at the operating position, the first switch 70A is ON. Here, when attention is focused on the first operation structural component W1, the first cover part T1 relatively moves in the accommodation recess 301 of the first operation section 3A in a direction of compressing the first spring 30A by receiving stress from the first switch 70A. In other words, when the first operation section 3A is pushed, the first cover part T1 is movable in a direction in which the first switch 70A is turned ON and the first spring 30A is compressed by the stress from the first switch 70A. Thus, the stress from the first switch 70A is absorbed by the first operation structural component W1. Thus, a good operation feeling can be provided to a user who pushes the first operation section 3A (improvement in operability). Moreover, the possibility that the first switch 70A is damaged is reduced. When the force pushing the first operation section 3A is no longer applied, the elastic return force of the return spring 40 and the elastic return force of the dome part 230 of the waterproof rubber member 23D return the first operation section 3A to the reference position, and the first switch 70A is thus turned OFF.

Then, the second operation structural component W2 will be described in detail with reference to FIGS. 15A and 15B.

The second spring 30B is a circular cone coil spring. The second spring 30B is, for example, a member substantially common to the first spring 30A in terms of shape and dimension. The second spring 30B has a first end 301B having a small diameter dimension and a second end 302B having a large diameter dimension. The second spring 30B is disposed with the first end 301B facing downward.

The second cover part T2 (an actuator), together with the second operation section 3B of the operation block body U1, encloses the second spring 30B. The second cover part T2 is made of, for example, a POM resin in a similar manner to the first cover part T1.

The second cover part T2 is, for example, a member substantially common to the first cover part T1 in terms of shape and dimension. That is, the second cover part T2 as a whole has a bowl shape with an upper surface being open. The second cover part T2 has a flange part T21. The flange part T21 is a part to be hooked on the plurality of pawls 302 of the second operation section 3B.

The second cover part T2 has a contact T22 at a central part of a lower surface thereof, and the contact T22 stepwise protrudes toward the second switch 70B. The contact T22 is a part that comes into contact with the second switch 70B which the contact T22 faces.

The second cover part T2 can accommodate part (a lower half part) of the second spring 30B from the upper surface, which is open. Note that a remaining part (an upper half part) of the second spring 30B is accommodated in the accommodation recess 303 of the second operation section 3B. The second cover part T2 has a support projection T23 (see FIG. 16A) on a bottom surface on an inner side thereof, and the support projection T23 protrudes toward the projection 31B. The support projection T23 is inserted into the first end 301B of the second spring 30B, and thereby, the second spring 30B is stably held in the interior of the second cover part T2. The accommodation recess 303 of the second operation section 3B is provided with a cylindrical part 311 cylindrically protruding downward from a peripheral portion of the pore 310. The cylindrical part 311 is inserted into the second end 302B of the second spring 30B, and thereby, the second spring 30B is stably held in the accommodation recess 303 of the second operation section 3B.

The second cover part T2 having such a configuration is held by the second operation section 3B by the flange part T21 being hooked on the plurality of pawls 302 of the second operation section 3B while accommodating the second spring 30B in a slightly compressed state with respect to the equilibrium length of the second spring 30B. In other words, the second cover part T2 is held by the second operation section 3B to cover the second spring 30B. The second switch 70B is disposed under the second cover part T2.

The second operation section 3B fixed by inserting the projection 231 on the left side of the waterproof rubber member 23D into the pore 310 of the projection 31B. In other words, the second operation structural component W2 is held by the waterproof rubber member 23D. When the second operation section 3B is at the reference position, the second switch 70B is OFF. Note that when the second operation section 3B is at the reference position, a gap may be provided between the second cover part T2 and the second switch 70B, or the second cover part T2 may be in direct contact with the second switch 70B.

When the second operation section 3B is at the operating position, the second switch 70B is ON. Moreover, in a similar manner to the first operation structural component W1, the second cover part T2 of the second operation structural component W2 relatively moves in the accommodation recess 303 of the second operation section 3B in a direction in which the second cover part T2 receives stress from the second switch 70B and compress the second spring 30B when the second cover part T2 comes into contact with the second switch 70B. In other words, when the second operation section 3B is pushed, the second cover part T2 is movable in a direction in which the second switch 70B is turned ON, and the second spring 30B is compressed by stress from the second switch 70B. Thus, a good operation feeling can be provided to a user who pushes the second operation section 3B (improvement in operability). Moreover, the possibility that the second switch 70B is damaged is reduced. When the force pushing the second operation section 3B is no longer applied, the elastic return force of the return spring 40 and the elastic return force of the dome part 230 of the waterproof rubber member 23D return the second operation section 3B to the reference position, and the second switch 70B is thus turned OFF.

### [Fourth Difference]

The input apparatus 1b includes the FPC 100 in place of the pair of first contact point springs 67 and the pair of second contact point springs 68 as described above. Moreover, in the input apparatus 1b, the first contact point spring 67 and the spring holder 66 for holding the second contact point spring 68 of the input apparatus 1 are also omitted.

In the present variation, an end (the left end), at the side of the fixed end, of the vibrator 61 is fixed to the bottom part 201 of the case body 2Y with the pair of attachment screws 65 and the pair of hex nuts N1, thereby being held by the housing 2.

In the present variation, the power generation device 6 is electrically connected via the FPC 100 to the substrate 7. The FPC 100 is bent into, for example, a substantially S-shape so as to be attached to sandwich both surfaces of the vibrator 61.

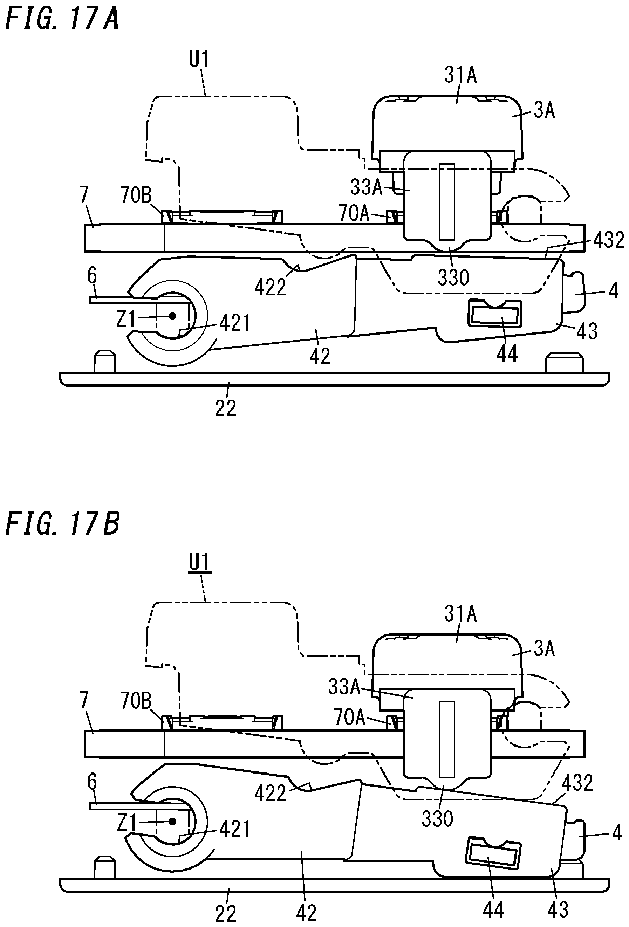

Moreover, in the present variation, the first pivot member 4 is attached to the pair of projections 206 provided on front and rear side surfaces on an inner side of the case body 2Y. The first pivot member 4 is configured to pivot about a first pivot axis Z1 (see FIGS. 17A to 18B) along the forward/rearward direction in interconnection with movement of the first operation section 3A and the second operation section 3B. Moreover, the first pivot member 4 holds a magnet 44. The magnet 44 is magnetically coupled to a magnetic weight 63 of the power generation device 6. When the first pivot member 4 pivots, the magnetic weight 63 moves downward together with the magnet 44. This enables the vibrator 61 to warp to vibrate.

Specifically, the first pivot member 4 of the input apparatus 1b includes a bottom part 41, a pair of attachment pieces 42, and a pair of holder pieces 43 in substantially the same manner as the input apparatus 1. The pair of attachment pieces 42 each have a through hole 421 which is circular, which is on the left of the bottom part 41, and which penetrates a corresponding one of the attachment pieces 42 in the forward/rearward direction. Note that each through hole 421 has a left edge portion which is open, and each attachment piece 42 has a left end which is substantially C-shaped when viewed along the forward/rearward direction.

The first pivot member 4 is attached to the case body 2Y by fitting the pair of projections 206 of the case body 2Y into the pair of through holes 421 formed in the pair of attachment pieces 42. The first pivot member 4 is configured to be pivotable about the first pivot axis Z1 which extends along the forward/rearward direction through the center of each of the pair of through holes 421. Thus, the bottom part 41 of the first pivot member 4 moves in the upward/downward direction between the vibrator 61 of the power generation device 6 and the bottom part 201 of the case body 2Y.

The pair of holder pieces 43 are provided on the right from the pair of attachment pieces 42 and between the pair of attachment pieces 42 in the forward/rearward direction. The pair of holder pieces 43 have through holes 431 which are rectangular and which penetrate the pair of holder pieces 43 in the forward/rearward direction. The magnet 44 is held by the pair of holder pieces 43 such that the magnet 44 extends through the pair of through holes 431 formed in the pair of holder pieces 43.

The bottom part 201 of the case body 2Y is provided with a restriction piece 225 (see FIGS. 12, 16A, and 16B). The restriction piece 225 defines a lower limit position of the free end (the right end) of the vibrator 61 in the movable range. The restriction piece 225 is provided along the forward/rearward direction to protrude upward from the bottom part 201. The restriction piece 225 extends through a through hole 411 provided in the bottom part 41 of the first pivot member 4, and a tip end (an upper end) of the restriction piece 225 comes into contact with the vibrator 61, thereby defining the lower limit position of the free end of the vibrator 61 in the movable range.

Moreover, between the bottom part 41 of the first pivot member 4 and the bottom part 201 of the case body 2Y, a single return spring 40 is disposed. The return spring 40 is a circular cone coil spring. The return spring 40 has a first end 401 having a small diameter dimension and a second end 402 having a large diameter dimension. The return spring 40 is disposed with the first end 401 facing upward. The return spring 40 is sandwiched between the bottom part 41 of the first pivot member 4 and the bottom part 201 of the case body 2Y. The bottom part 201 of the case body 2Y has a recess 210 (see FIG. 12) in which the second end 402 of the return spring 40 is to be fit. The recess 210 is recessed downward in a substantially circular shape and has a peripheral edge provided with a pair of pawls 211 on which the second end 402 is to be hooked.

The return spring 40 applies elastic force to the first pivot member 4 such that the first pivot member 4 is at an upper limit position in the movable range. In the following description, the upper limit position of the first pivot member 4 in the movable range is referred to as a "first start position" (see FIGS. 16A, 17A, and 18A).

The pair of holder pieces 43 have a pair of first pressure receiving parts 432 provided at upper ends thereof. In the present variation, the pair of first pressure receiving parts 432 have flat surfaces along the rightward/leftward direction. In the first start position, a gap may be provided between each of the pair of first pressure receiving parts 432 and a corresponding one of the pair of protruding pieces 33A of the first operation section 3A, or the pair of first pressure receiving parts 432 may be in direct contact with the pair of protruding pieces 33A. When the first operation section 3A is pushed, the pair of first pressure receiving parts 432 receive downward force from the pair of protruding pieces 33A. Thus, the first pivot member 4 pivotally moves about the first pivot axis Z1 to a lower end position in the movable range while compressing the return spring 40. In the following description, the lower limit position of the first pivot member 4 in the movable range is referred to as a "first end position" (see FIGS. 16B, 17B, and 18B).

Moreover, the first pivot member 4 further includes a pair of second pressure receiving parts 422. In the first start position, a gap may be provided between each of the pair of second pressure receiving parts 422 and a corresponding one of the pair of pressing parts 522 of the second pivot member 5, or the pair of second pressure receiving parts 422 may be in direct contact with the pair of pressing parts 522. When the second operation section 3B is pushed, the pair of second pressure receiving parts 422 receive downward force from the pressing parts 522 of the second pivot member 5. Thus, the first pivot member 4 pivotally moves about the first pivot axis Z1 to the lower end position (the first end position) in the movable range while compressing the return spring 40.

Moreover, in the present variation, the second pivot member 5 is attached to the pair of projections 208 provided on front and rear side surfaces on in inner side of the case body 2Y. In the present variation, the second pivot member 5 is integrated with the second operation section 3B and is thus configured to pivot together with the second operation section 3B about the second pivot axis Z2 (see FIGS. 18A and 18B) along the forward/rearward direction. When the second pivot member 5 pivots, the second pressure receiving parts 422 are pushed, so that the first pivot member 4 pivots. This enables the vibrator 61 to warp to vibrate. Note that the first operation section 3A is configured to move between the pair of arms U3 of the second pivot member 5 in the upward/downward direction to push the first pressure receiving parts 432 of the first pivot member 4. The second pivot member 5 pivotably moves about the second pivot axis Z2 from an upper limit position to a lower limit position of the second pivot member 5 in the movable range. In the following description, the upper limit position of the second pivot member 5 in the movable range is referred to as a "second start position", and the lower limit position of the second pivot member 5 in the movable range is referred to as a "second end position" (see FIGS. 18A and 18B).

### [Operation of Second Variation]

Operation of the input apparatus 1b of the present variation will be described below. Note that description of operation common to the operation of the input apparatus 1 of the embodiment described above may be accordingly omitted.

First, power generation operation of the power generation device 6 will be described with reference to FIGS. 16A to 16B. FIG. 16A shows a state where the first pivot member 4 is in the first start position. FIG. 16B shows a state where the first pivot member 4 is in the first end position.

As illustrated in FIG. 16A, when the first pivot member 4 is in the first start position, the magnetic weight 63 provided at the free end of the vibrator 61 is magnetically attracted to the magnet 44 held by the first pivot member 4.

When the first operation section 3A or the second operation section 3B is pushed, the first pivot member 4 pivots about the first pivot axis Z1 in a clockwise direction viewed from the front. FIG. 16B shows an example in which the first operation section 3A is pushed. More specifically, when the dome part 230 (in the example shown in the figure, on the right side) of the waterproof rubber member 23D is pushed, a surrounding part of the dome part 230 is warped such that the dome part 230 is depressed downward. Then, the entirety of the first operation structural component W1 including the first operation section 3A fixed to the dome part 230 moves in a direction (downward) toward the first switch 70A. Before the first operation section 3A is pushed, the contact T12 of the first cover part T1 is apart from the first switch 70A as illustrated in FIG. 16A. When the first operation section 3A is pushed, the contact T12 comes into contact with the first switch 70A. When the first operation section 3A is further pushed after the contact T12 comes into contact with the first switch 70A, the first switch 70A is turned ON, and the first cover part T1 receives stress from the first switch 70A. As a result, when viewed from the first operation section 3A, the first cover part T1 relatively moves in a direction in which the first spring 30A accommodated in the first operation section 3A and the first cover part T1 is compressed. Note that although not shown in the figure, also when the dome part 230 on the left side is pushed, the entirety of the second operation structural component W2 including the second operation section 3B fixed to the dome part 230 moves in a direction (downward) toward the second switch 70B. When the second operation section 3B is further pushed after the contact T22 of the second cover part T2 comes into contact with the second switch 70B, the second switch 70B is turned ON, and the second cover part T2 receives stress from the second switch 70B. As a result, when viewed from the second operation section 3B, the second cover part T2 relatively moves in a direction in which the second spring 30B accommodated in the second operation section 3B and the second cover part T2 is compressed.

Moreover, as the first pivot member 4 pivots, the magnet 44 and the magnetic weight 63 magnetically attracted to the magnet 44 moves downward. Thus, the vibrator 61 is warped such that the free end (the right end) is located below the fixed end (the left end). When the first pivot member 4 move to the first end position, the vibrator 61 then comes into contact with the restriction piece 225, which releases the magnetic attraction between the magnet 44 and the magnetic weight 63. Thus, the vibrator 61 vibrates such that the free end (the right end) reciprocally moves in the upward/downward direction by the elastic force of the vibrator 61, and the piezoelectric element 62 thus generates electric power.

When the force pushing the first operation section 3A or the second operation section 3B is released, the elastic force of the return spring 40 moves the first pivot member 4 from the first end position to the first start position. The first pivot member 4 returns to the first start position, and thereby, the magnet 44 and the magnetic weight 63 are magnetically attracted to each other to stop vibration of the vibrator 61.

Thus, the first pivot member 4 pivots about the first pivot axis Z1 from the first start position (see FIG. 16A) to the first end position (see FIG. 16B), and thereby, the power generation device 6 generates electric power.

Next, operation of the first pivot member 4 when the first operation section 3A is pushed will be described with reference to FIGS. 17A and 17B. FIG. 17A shows a state where the first operation section 3A is not pushed, that is, in the reference position. FIG. 17B shows a state where the first operation section 3A is pushed, that is, in the operating position. Note that in FIGS. 17A and 17B, the case 21 and the like are accordingly omitted.

The first operation section 3A is held by the waterproof rubber member 23D and is at the reference position in the steady state where the first operation section 3A is not pushed (see FIG. 17A). At this time, the first pivot member 4 is at the first start position due to the elastic force of the spring 40.

When the first operation section 3A is pushed, projections 330 protruding in an arc-like form and provided at lower ends of the pair of protruding pieces 33A apply downward force to the pair of first pressure receiving parts 432 of the first pivot member 4. When the downward force is applied to the pair of first pressure receiving parts 432, the first pivot member 4 pivots about the first pivot axis Z1 from the first start position (see FIG. 17A) to the first end position (see FIG. 17B). That is, also in this variation, when the first operation section 3A is pushed, the first operation section 3A directly transmits, to the first pivot member 4, force that causes the first pivot member 4 to pivot. At this time, no force is transmitted from the first operation section 3A to the second pivot member 5, and therefore, the operation block body U1 including the second pivot member 5 remains at the second start position.

As described above, when the first operation section 3A is pushed, the downward force applied to the first operation section 3A is directly transmitted to the first pivot member 4, and the power generation device 6 thus generates electric power.

Next, operation of the second pivot member 5 when the second operation section 3B is pushed will be described with reference to FIGS. 18A and 18B. FIG. 18A shows a state where the second operation section 3B is not pushed, that is, in the reference position. FIG. 18B shows a state where the second operation section 3B is pushed, that is, in the operating position. Note that in FIGS. 18A and 18B, the case 21 and the like are accordingly omitted.

The second operation section 3B is held by the waterproof rubber member 23D and is at the reference position in the steady state where the second operation section 3B is not pushed (see FIG. 18A). At this time, the first pivot member 4 is at the first start position due to the elastic force of the spring 40. Note that in FIG. 18A, the pair of second pressure receiving parts 422 of the first pivot member 4 are slightly apart from the pair of pressing parts 522 of the second pivot member 5. Alternatively, the second pressure receiving parts 422 may be in contact with the pressing parts 522 also in the steady state. When these parts are in contact with each other also in the steady state, the elastic force of the return spring 40 is transmitted via the first pivot member 4 to the second pivot member 5, and the second pivot member 5 is stably kept at the second start position.

When the second operation section 3B is pushed, the second pivot member 5 integrated with the second operation section 3B pivots about the second pivot axis Z2 from the second start position (see FIG. 18A) to the second end position (see FIG. 18B). In sum, when the second operation section 3B is pushed, the entirety of the operation block body U1 pivots about the second pivot axis Z2.

When the entirety of the operation block body U1 pivots, the pair of pressing parts 522 apply downward force to the pair of second pressure receiving parts 422 of the first pivot member 4. When the downward force is applied to the pair of second pressure receiving parts 422, the first pivot member 4 pivots about the first pivot axis Z1 from the first start position (see FIG. 18A) to the first end position (see FIG. 18B).

That is, also in this variation, when pushed, the second operation section 3B indirectly transmits, via the second pivot member 5 to the first pivot member 4, force that causes the first pivot member 4 to pivot.

As described above, when the second operation section 3B is pushed, the downward force applied to the second operation section 3B is indirectly transmitted via the second pivot member 5 to the first pivot member 4, and the power generation device 6 thus generates electric power.

### (Other Variations)

Each example described above is configured such that the magnetic force of the magnet 44 is used to vibrate the vibrator 61, but this configuration should not be construed as limiting. For example, to vibrate the vibrator 61, the free end of the vibrator 61 may be flipped with a claw provided to the first pivot member 4. In this case, in the course of the first pivot member 4 pivoting from the first start position toward the first end position, the claw comes into contact with the vibrator 61 and flips the vibrator 61. Thus, the vibrator 61 vibrates, so that the piezoelectric element 62 generates electric power.

Moreover, in the example described above, the input apparatus 1 includes the two operation sections (the first operation section 3A and the second operation section 3B) to be pushed downward and the switches (the first switch 70A and the second switch 70B) corresponding to the two operation sections, but this should not be construed as limiting. The input apparatus 1 may include three or more operation sections to be pushed downward and three or more switches corresponding to the three or more operation sections.

Moreover, in the example described above, the input apparatus 1a includes a single third operation section 3C to be pushed in the leftward direction and a single third switch 70C corresponding to the single third operation section 3C, but this should not be construed as limiting. The input apparatus 1a may include two or more operation sections to be pushed in the leftward direction and two or more switches corresponding to the two or more operation sections. Moreover, the input apparatus 1a may include an operation section to be pushed in a direction different from the downward and leftward directions and a switch corresponding to the operation section.

### (Summary)

An input apparatus (1, 1a, 1b) according to a first aspect includes a first operation section (3A) configured to receive a push operation, a second operation section (3B) configured to receive a push operation, a first pivot member (4) configured to pivot, a second pivot member (5) configured to pivot, a first switch (70A), a second switch (70B), and a power generation device (6). The power generation device (6) is configured to generating electric power when the first pivot member (4) pivots. When the first operation section (3A) is pushed, the first switch (70A) is turned ON and the first pivot member (4) directly receives force from the first operation section (3A) to pivot. When the second operation section (3B) is pushed, the second switch (70B) is turned ON and the first pivot member (4) indirectly receives force from the second operation section (3B) via the second pivot member (5) to pivot.

This aspect enables first operation force which gives a push operation to the first operation section (3A) and second operation force which gives a push operation to the second operation section (3B) to be adjusted.

In an input apparatus (1, 1a, 1b) of a second aspect referring to the first aspect, the first pivot member (4) is configured to, when the first operation section (3A) or the second operation section (3B) is pushed, pivot in a direction opposite to a direction in which the second pivot member (5) pivots when the second operation section (3B) is pushed.

This aspect enables first operation force which gives a push operation to the first operation section (3A) and second operation force which gives a push operation to the second operation section (3B) to be adjusted.

In an input apparatus (1, 1a, 1b) of a third aspect referring to the first or second aspect, wherein the power generation device (6) is configured to, when the first operation section (3A) is pushed, generate the electric power after the first switch (70A) is turned ON. The power generation device (6) is configured to, when the second operation section (3B) is pushed, generate the electric power after the second switch (70B) is turned ON.

This aspect suppresses the first switch (70A) or the second switch (70B) from being OFF when the power generation device (6) performs the power generation.

An input apparatus (1, 1a, 1b) of a fourth aspect referring to the third aspect further includes: a first spring (30A) provided between the first operation section (3A) and the first switch (70A); and a second spring (30B) provided between the second operation section (3B) and the second switch (70B). A timing at which the first switch (70A) is turned ON when the first operation section (3A) is pushed is adjusted by elastic force of the first spring (30A). A timing at which the second switch (70B) is turned ON when the second operation section (3B) is pushed is adjusted by elastic force of the second spring (30B).

This aspect enables a simple configuration to adjust the timing at which the first switch (70A) is turned ON and the timing at which the second switch (70B) is turned ON.

An input apparatus (1b) of a fifth aspect referring to the fourth aspect further includes: a first cover part (T1) and a second cover part (T2). The first cover part (T1) is held by the first operation section (3A) to cover the first spring (30A). The second cover part (T2) is held by the second operation section (3B) to cover the second spring (30B). The first cover part (T1) is configured to, when the first operation section (3A) is pushed, move in a direction in which the first switch (70A) is turned ON and the first spring (30A) is compressed by stress from the first switch (70A). The second cover part (T2) is configured to, when the second operation section (3B) is pushed, move in a direction in which the second switch (70B) is turned ON and the second spring (30B) is compressed by stress from the second switch (70B).

With this aspect, operability is more improved than in a case where the first spring (30A) and the second spring (30B) respectively come into contact with and thus turn on the first switch (70A) and the second switch (70B). Moreover, this aspect reduces the possibility that the first switch (70A) and the second switch (70B) are damaged.

In an input apparatus (1, 1a, 1b) of a sixth aspect referring to any one of the first to fifth aspects, the second pivot member (5) has a pair of pressing parts (522) configured to apply force to the first pivot member (4). The pair of pressing parts (522) are provided on both sides of the power generation device (6).

With this aspect, the first pivot member (4) and the second pivot member (5) are suppressed from interfering with the power generation device (6), and therefore, the power generation device (6) can be increased in size to increase the power generation amount thereof.

An input apparatus (1, 1a, 1b) of a seventh aspect referring to the sixth aspect further includes a substrate (7) electrically connected to the power generation device (6). The substrate (7) is provided between the pair of pressing parts (522).

With this aspect, the first pivot member (4) and the second pivot member (5) are suppressed from interfering with the substrate (7), and therefore, the substrate (7) can be increased in size.

In an input apparatus (1, 1a, 1b) of an eighth aspect referring to any one of the first to seventh aspects, the power generation device (6) includes a vibrator (61) and a piezoelectric element (62) provided to the vibrator (61).

This aspect enables the piezoelectric element (62) to convert vibration energy of the vibrator (61) into electrical energy.

An input apparatus (1, 1a, 1b) of a ninth aspect referring to the eighth aspect further includes a magnet (44) held by the first pivot member (4), wherein the vibrator (61) is configured to be vibrated by the magnetic force of the magnet.

This aspect enables the magnet (44) to be more suppressed from being worn or the like than a configuration in which a claw vibrates the vibrator (61), so that service life is extended.

An input apparatus (1a) of a tenth aspect referring to any one of the first to ninth aspects further includes: a third operation section (3C) configured to receive a push operation; and a third switch (70C). When the third operation section (3C) is pushed, the third switch (70C) is turned ON, and the first pivot member (4) directly or indirectly receives force from the third operation section (3C) to pivot.

This aspect enables the power generation device (6) to generate electric power whether the first switch (70A), the second switch (70B), or the third switch (70C) is pushed.

In an input apparatus (1a) of an eleventh aspect referring to the tenth aspect, the third operation section (3C) is configured to be pushed in a direction orthogonal to a direction in which each of the first operation section (3A) and the second operation section (3B) is pushed.

With this aspect, the third operation section (3C) is disposed to be pushed in a direction other than the direction in which each of the first operation section (3A) and the second operation section (3B) is pushed, and therefore, downsizing of the input apparatus (1a) is achieved.

An input apparatus (1, 1a, 1b) of a twelfth aspect referring to any one of the first to eleventh aspects further includes a transmission circuit (73) configured to output a radio signal. The transmission circuit (73) is configured to output the radio signal by using electric power generated by the power generation device (6).

This aspect enables the radio signal to be output in interconnection with a push operation given to the first switch (70A) or the second switch (70B).

In an input apparatus (1b) of a thirteenth aspect referring to any one of the first to twelfth aspects, the second operation section (3B) is integrated with the second pivot member (5).

This aspect enables the number of components to be reduced and cost to be reduced.

### Reference Signs List

- 1, 1a, 1b: INPUT APPARATUS
- 3A: FIRST OPERATION SECTION
- 3B: SECOND OPERATION SECTION
- 3C: THIRD OPERATION SECTION
- 4: FIRST PIVOT MEMBER
- 5: SECOND PIVOT MEMBER
- 70A: FIRST SWITCH
- 70B: SECOND SWITCH
- 70C: THIRD SWITCH
- 6: POWER GENERATION DEVICE
- 30A: FIRST SPRING
- 30B: SECOND SPRING
- 522: PRESSING PART
- 7: SUBSTRATE
- 61: VIBRATOR
- 62: PIEZOELECTRIC ELEMENT
- 44: MAGNET

- 73: TRANSMISSION CIRCUIT

## Claims

1. An input apparatus, comprising:
a first operation section configured to receive a push operation;
a second operation section configured to receive a push operation;
a first pivot member configured to pivot;
a second pivot member configured to pivot;
a first switch;
a second switch; and
a power generation device configured to generate electric power when the first pivot member pivots,
when the first operation section is pushed, the first switch being turned ON and the first pivot member directly receiving force from the first operation section to pivot,
when the second operation section is pushed, the second switch being turned ON and the first pivot member indirectly receiving force from the second operation section via the second pivot member to pivot.

2. The input apparatus of claim 1, wherein
the first pivot member is configured to, when the first operation section or the second operation section is pushed, pivot in a direction opposite to a direction in which the second pivot member pivots when the second operation section is pushed.

3. The input apparatus of claim 1 or 2, wherein
the power generation device is configured to, when the first operation section is pushed, generate the electric power after the first switch is turned ON, and
the power generation device is configured to, when the second operation section is pushed, generate the electric power after the second switch is turned ON.

4. The input apparatus of claim 3, further comprising:
a first spring provided between the first operation section and the first switch; and
a second spring provided between the second operation section and the second switch, wherein
a timing at which the first switch is turned ON when the first operation section is pushed is adjusted by elastic force of the first spring, and
a timing at which the second switch is turned ON when the second operation section is pushed is adjusted by elastic force of the second spring.

5. The input apparatus of claim 4, further comprising:
a first cover part held by the first operation section to cover the first spring; and
a second cover part held by the second operation section to cover the second spring, wherein
the first cover part is configured to, when the first operation section is pushed, move in a direction in which the first switch is turned ON and the first spring is compressed by stress from the first switch, and
the second cover part is configured to, when the second operation section is pushed, move in a direction in which the second switch is turned ON and the second spring is compressed by stress from the second switch.

6. The input apparatus of any one of claims 1 to 5, wherein
the second pivot member has a pair of pressing parts configured to apply force to the first pivot member, and
the pair of pressing parts are provided on both sides of the power generation device.

7. The input apparatus of claim 6, further comprising a substrate electrically connected to the power generation device, wherein
the substrate is provided between the pair of pressing parts.

8. The input apparatus of any one of claims 1 to 7, wherein
the power generation device includes a vibrator and a piezoelectric element provided to the vibrator.

9. The input apparatus of claim 8, further comprising a magnet held by the first pivot member, wherein
the vibrator is configured to be vibrated by magnetic force of the magnet.

10. The input apparatus of any one of claims 1 to 9, further comprising:
a third operation section configured to receive a push operation; and
a third switch, wherein
when the third operation section is pushed, the third switch is turned ON, and the first pivot member directly or indirectly receives force from the third operation section to pivot.

11. The input apparatus of claim 10, wherein
the third operation section is configured to be pushed in a direction orthogonal to a direction in which each of the first operation section and the second operation section is pushed.

12. The input apparatus of any one of claims 1 to 11, further comprising a transmission circuit configured to output a radio signal, wherein
the transmission circuit is configured to output the radio signal by using electric power generated by the power generation device.

13. The input apparatus of any one of claims 1 to 12, wherein
the second operation section is integrated with the second pivot member.
